(19) **Europäisches Patentamt / European Patent Office / Office européen des brevets**

(11) **EP 4 682 861 A1**

(12) **EUROPEAN PATENT APPLICATION**
published in accordance with Art. 153(4) EPC

(43) Date of publication:
**21.01.2026 Bulletin 2026/04**

(21) Application number: **23958492.3**

(22) Date of filing: **13.11.2023**

(51) International Patent Classification (IPC):
**G09G 3/3208** (2016.01)    **G09G 3/3233** (2016.01)
**H10D 86/00** (2025.01)

(52) Cooperative Patent Classification (CPC):
**G09G 3/3208; G09G 3/3233**

(86) International application number:
**PCT/CN2023/131251**

(87) International publication number:
**WO 2025/102205 (22.05.2025 Gazette 2025/21)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **Boe Technology Group Co., Ltd.**
**Beijing 100015 (CN)**
• **Beijing BOE Technology Development Co., Ltd.**
**Beijing 100176 (CN)**

(72) Inventors:
• **YANG, Mingkun**
**Beijing 100176 (CN)**
• **HUANGFU, Lujiang**
**Beijing 100176 (CN)**
• **HAO, Xueguang**
**Beijing 100176 (CN)**
• **LIU, Lang**
**Beijing 100176 (CN)**

(74) Representative: **Isarpatent**
**Patent- und Rechtsanwälte Partg mbB**
**Friedrichstraße 31**
**80801 München (DE)**

(54) **DISPLAY SUBSTRATE AND DRIVING METHOD THEREFOR, AND DISPLAY DEVICE**

(57)    Provided are a display substrate, a method for driving the same and a display device. The display substrate includes sub-pixels including sub-pixel driving circuits, each of which includes driving transistor, data writing transistor, first capacitor, second capacitor; first and second plates of the first capacitor are respectively coupled to a gate of the driving transistor and second electrode of the data writing transistor, first electrode of the data writing transistor is coupled to corresponding data line; first and second plates of the second capacitor are respectively coupled to second plate of the first capacitor and corresponding power supply line; among sub-pixel driving circuits in one row along first direction, second plates of second capacitors in the sub-pixel driving circuits are along the first direction, spacing exists between second plates of adjacent second capacitors, projection of the data line onto base partially overlaps projection of the spacing onto the base.

FIG. 14

EP 4 682 861 A1

## Description

## TECHNICAL FIELD

The present disclosure relates to the field of display technology, in particular to a display substrate, a method for driving the same and a display device.

## BACKGROUND

Organic light-emitting diode (OLED) display products have been widely used in various fields due to advantages such as high brightness and active light-emission. However, the current OLED display product has a low refresh rate, and is not applicable in high refresh rate scenarios. In order to achieve high-frequency display of the OLED display product, a separate sub-pixel driving circuit scheme is adopted in the OLED display product, i.e., to independently control a compensation stage and a data writing stage of the sub-pixel driving circuit. This control method achieves high-frequency display to a certain extent.

## SUMMARY

The present disclosure is to provide a display substrate, a method for driving the same and a display device.

In order to achieve the above objective, the present disclosure provides the following technical solutions.

The first aspect of the present disclosure provides a display substrate, which includes: a base substrate, and power supply lines, data lines and a plurality of sub-pixels that are arranged on the base substrate. The sub-pixel includes a sub-pixel driving circuit and a light-emitting element coupled to each other, and the sub-pixel driving circuit includes a driving transistor, a data writing transistor, a first capacitor and a second capacitor; a first plate of the first capacitor is coupled to a gate electrode of the driving transistor, a second plate of the first capacitor is coupled to a second electrode of the data writing transistor, and a first electrode of the data writing transistor is coupled to a corresponding one of the data lines; a first plate of the second capacitor is coupled to the second plate of the first capacitor, and a second plate of the second capacitor is coupled to a corresponding one of the power supply lines; among sub-pixel driving circuits located in a same row along a first direction, second plates of second capacitors included in the sub-pixel driving circuits are arranged in sequence along the first direction, there is a spacing region between second plates of adjacent second capacitors, and an orthographic projection of the data line onto the base substrate at least partially overlaps an orthographic projection of the spacing region onto the base substrate.

Optionally, the second plates of the adjacent second capacitors along the first direction are coupled to each other through a plate connection part, the spacing region and the plate connection part are arranged along a second direction between the second plates of the adjacent second capacitors, and the first direction intersects the second direction; the orthographic projection of the data line onto the base substrate at least partially overlaps an orthographic projection of the plate connection part onto the base substrate.

Optionally, the display substrate further includes a first initialization signal line; the sub-pixel driving circuit further includes a first compensation transistor and a first reset transistor; a first electrode of the first compensation transistor is coupled to the second electrode of the driving transistor, and a second electrode of the first compensation transistor is coupled to the gate electrode of the driving transistor; a first electrode of the first reset transistor is coupled to the corresponding first initialization signal line, and a second electrode of the first reset transistor is coupled to the gate electrode of the driving transistor; the first compensation transistor includes a first compensation active layer, and the first reset transistor includes a first reset active layer; the plate connection part includes a connection body portion and a connection extension portion that are coupled to each other, the connection body portion is coupled to the second plates of the adjacent second capacitors, and an orthographic projection of the connection extension portion onto the base substrate at least partially overlaps an orthographic projection of the first compensation active layer onto the base substrate included in one sub-pixel driving circuit of two adjacent sub-pixel driving circuits along the first direction, and/or at least partially overlaps an orthographic projection of the first reset active layer onto the base substrate included in another sub-pixel driving circuit of the two adjacent sub-pixel driving circuits along the first direction; the orthographic projection of the data line onto the base substrate at least partially overlaps an orthographic projection of the connection body portion onto the base substrate; and/or, the orthographic projection of the data line onto the base substrate at least partially overlaps the orthographic projection of the connection extension portion onto the base substrate.

Optionally, the first compensation active layer includes two first compensation channel portions, and first compensation conductor portions respectively coupled to the two first compensation channel portions; the first reset active layer includes two first reset channel portions, and first reset conductor portions respectively coupled to the two first reset channel portions; the orthographic projection of the connection extension portion onto the base substrate at least partially overlaps orthographic projections of the first compensation conductor portions onto the base substrate included in one sub-pixel driving circuit of two adjacent sub-pixel driving circuits along the first direction, and/or at least partially overlaps orthographic projections of the first reset conductor portions onto the base substrate included in another sub-pixel driving circuit of the two adjacent sub-pixel driving circuits along the first direction.

Optionally, the display substrate further includes a plurality of first reference signal connection lines and a plurality of second reference signal connection lines, and the first reference signal connection lines and the second reference signal connection lines are alternately arranged along the first direction; an orthographic projection of at least portion of the data line onto the base substrate is located between orthographic projections of the first reference signal connection line and the second reference signal connection line that are adjacent onto the base substrate; the data line and the first reference signal connection line are arranged in different layers; and/or the data line and the second reference signal connection line are arranged in different layers.

Optionally, the display substrate further includes a plurality of first reference signal lines; the sub-pixel driving circuit further includes a second reset transistor, a first electrode of the second reset transistor is coupled to a corresponding one of the first reference signal lines, and a second electrode of the second reset transistor is coupled to the second plate of the first capacitor; the first reference signal connection lines are respectively coupled to the plurality of first reference signal lines.

Optionally, the display substrate further includes a plurality of second reference signal lines; the sub-pixel driving circuit further includes a third reset transistor, a first electrode of the third reset transistor is coupled to a corresponding one of the second reference signal line, and a second electrode of the third reset transistor is coupled to the first electrode of the driving transistor; the second reference signal connection lines are respectively coupled to the plurality of second reference signal lines.

Optionally, the display substrate further includes a plurality of first initialization signal connection lines and a plurality of second initialization signal connection lines, and the first initialization signal connection lines and the second initialization signal connection lines are alternately arranged along the first direction; an orthographic projection of at least portion of the data line onto the base substrate is located between orthographic projections of a first initialization signal connection line and a second initialization signal connection line that are adjacent onto the base substrate, the data line and the first initialization signal connection line are arranged in different layers; and/or, the data line and the second initialization signal connection line are arranged in different layers.

Optionally, the display substrate further includes a plurality of first initialization signal lines; the sub-pixel driving circuit further includes a first reset transistor, a first electrode of the first reset transistor is coupled to a corresponding one of the first initialization signal lines, and the second electrode of the first reset transistor is coupled to the gate electrode of the driving transistor; the first initialization signal connection lines are respectively coupled to the plurality of first initialization signal lines.

Optionally, the display substrate further includes a plurality of second initialization signal lines; the sub-pixel driving circuit further includes a fourth reset transistor, a first electrode of the fourth reset transistor is coupled to a corresponding one of the second initialization signal lines, and a second electrode of the fourth reset transistor is coupled to an anode of the light-emitting element; the second initialization signal connection lines are respectively coupled to the plurality of second initialization signal lines.

Optionally, the display substrate includes a first source-drain metal layer, a second source-drain metal layer, and a third source-drain metal layer sequentially stacked in a direction away from the base substrate; the data line and the third source drain metal layer are arranged in a same layer and fabricated by a same material, and the first reference signal connection line, the second reference signal connection line, the first initialization signal connection line, and the second initialization signal connection line are arranged in a same layer and fabricated by a same material as the second source drain metal layer.

Optionally, the display substrate further includes a plurality of data line leads; the display substrate includes a plurality of data lines arranged along the first direction, and the plurality of data lines are divided into a first group of data lines, a second group of data lines and a third group of data lines arranged along the first direction; a data line in the first group of data lines is coupled to a corresponding one of the data line leads, and the data line lead extends from a position where the data line lead and the data line are coupled to a middle area of the display substrate, and extends from the middle area to a bottom border area of the display substrate; a data line in the third group of data lines is coupled to a corresponding one of the data line leads, and the data line lead extends from a position where the data line lead and the data line are coupled to the middle area, and extends from the middle area to the bottom border area.

Optionally, the display substrate includes a first source-drain metal layer, a second source-drain metal layer, and a third source-drain metal layer sequentially stacked in a direction away from the base substrate; the data line and the second source drain metal layer are arranged in a same layer and fabricated by a same material, and the first reference signal connection line, the second reference signal connection line, the first initialization signal connection line, and the second initialization signal connection line are arranged in a same layer and fabricated by a same material as the third source drain metal layer.

Optionally, the display substrate includes a light shielding layer, a first source-drain metal layer, a second source-drain metal layer and a third source-drain metal layer that are sequentially stacked in a direction away from the base substrate; the data line are arranged in a same layer and fabricated by a same material as the light shielding layer, the first reference signal connection line, the second reference signal connection line, the first initialization signal connection line, and the second initialization signal connection line are arranged in a same layer and fabricated by a same material as the second source drain metal layer.

Optionally, the display substrate further includes a plurality of power supply connection lines, at least portion of the power supply connection lines extends along the first direction, and the power supply connection lines are respectively coupled to the plurality of power supply lines.

Optionally, the power supply connection line includes a plurality of first power supply portions and a plurality of second power supply portions, and the first power supply portions and the second power supply portions are alternately arranged along the first direction; the first power supply portion includes a first sub-portion and a second sub-portion, the first sub-portion is coupled to the second sub-portion and the power supply line, the second sub-portion and the second power supply portion that are adjacent are coupled to each other, a width of the second power supply portion along the second direction is greater than a width of the second sub-portion along the second direction, and an orthographic projection of the second power supply portion onto the base substrate at least partially overlaps the orthographic projection of the data line onto the base substrate.

Optionally, the sub-pixel further includes a first scan line and a control signal line; the sub-pixel driving circuit further includes a first compensation transistor and a second compensation transistor, a gate electrode of the first compensation transistor is coupled to the corresponding first scan line, a first electrode of the first compensation transistor is coupled to the second electrode of the driving transistor, and a second electrode of the first compensation transistor is coupled to the gate electrode of the driving transistor; a gate electrode of the second compensation transistor is coupled to the corresponding control signal line, a first electrode of the second compensation transistor is coupled to a corresponding one of the power supply lines, and a second electrode of the second compensation transistor is coupled to the first electrode of the driving transistor.

Optionally, in one of the sub-pixel drive circuits, the control signal line coupled to the gate electrode of the second compensation transistor is reused as the first scan line coupled to the gate electrode of the first compensation transistor.

Optionally, the plurality of sub-pixels include a red sub-pixel, a green sub-pixel and a blue sub-pixel, the sub-pixel driving circuit in the red sub-pixel includes a driving transistor having a first channel width-to-length ratio, the sub-pixel driving circuit in the green sub-pixel includes a driving transistor having a second channel width-to-length ratio, and the sub-pixel driving circuit in the blue sub-pixel includes a driving transistor having a third channel width-to-length ratio; the third channel width-to-length ratio is greater than the first channel width-to-length ratio; and/or, the third channel width-to-length ratio is greater than the second channel width-to-length ratio.

On the basis of the technical solution of the above display substrate, in a second aspect, a display device is provided by the present disclosure, which includes the above display substrate.

On the basis of the technical solution of the above display substrate, in a third aspect, a method for driving a display device is provided by the present disclosure, which is configured for driving the above display substrate. The driving method includes: in a data writing stage, turning on the data writing transistor, writing a data signal transmitted by the data line into the second plate of the first capacitor, to enable the first capacitor to couple a potential jump of the second plate of the first capacitor to the first plate included by the first capacitor.

Optionally, the sub-pixel driving circuit further includes a first compensation transistor and a second compensation transistor, among one of the sub-pixel driving circuits, the control signal line coupled to the gate electrode of the second compensation transistor is reused as the first scan line coupled to the gate electrode of the first compensation transistor; the driving method further includes: in a compensation stage, setting a control signal transmitted by the control signal line at an effective level to turn on both the first compensation transistor and the second compensation transistor under the control of the control signal, where there is a first time interval t1 between a moment when the effective level of the control signal ends and a moment when the data writing transistor T1 is turned on, and t1 satisfies t1 ≤ m, where m represents a first threshold.

**BRIEF DESCRIPTION OF THE DRAWINGS**

The accompanying drawings described herein are intended to facilitate further understanding of the present disclosure and form a part of the present disclosure. The illustrative embodiments of the present disclosure and their descriptions are used to explain the present disclosure and do not constitute undue limitations onto the present disclosure. In the accompanying drawings:

FIG. 1 is a schematic structural diagram of a first circuit of a sub-pixel driving circuit provided in an embodiment of the present disclosure;
FIG. 2 shows a first driving timing diagram of a sub-pixel driving circuit provided in an embodiment of the present disclosure;
FIG. 3 is a schematic structural diagram of a second circuit of a sub-pixel driving circuit provided in an embodiment of the present disclosure;
FIG. 4 is a schematic structural diagram of a third circuit of a sub-pixel driving circuit provided in an embodiment of the present disclosure;

FIG. 5 shows a second driving timing diagram of a sub-pixel driving circuit provided in an embodiment of the present disclosure;

FIG. 6 is a schematic layout diagram of an active layer of a driving transistor in related technologies;

FIG. 7 is a schematic diagram of a first layout of an active layer of a sub-pixel driving circuit provided in an embodiment of the present disclosure;

FIG. 8 is a schematic diagram of a second layout of an active layer of a sub-pixel driving circuit provided in an embodiment of the present disclosure;

FIG. 9 is a schematic diagram of a first layout of an active layer and a first gate metal layer of a sub-pixel driving circuit provided in an embodiment of the present disclosure;

FIG. 10 is a schematic diagram of a first layout of a second gate metal layer of a sub-pixel driving circuit provided in an embodiment of the present disclosure;

FIG. 11 is a schematic diagram of a first layout in case of adding a second gate metal layer on the basis of FIG. 9;

FIG. 12 is a schematic diagram of a first layout of via holes in case of adding a first source drain metal layer and an intermediate insulation layer on the basis of FIG. 11;

FIG. 13 is a schematic diagram of a first layout of the via holes of the first source drain metal layer and the intermediate insulation layer added in FIG. 12;

FIG. 14 is a schematic diagram of a first layout of via holes in case of adding a second source drain metal layer and a first planarization layer on the basis of FIG. 12;

FIG. 15 is a schematic diagram of a first layout of via holes of the second source drain metal layer and the first planarization layer added in FIG. 14;

FIG. 16 is a schematic cross-sectional view taken along an F1F2 direction in FIG. 14;

FIG. 17 is a schematic diagram of a second layout of sub-pixel driving circuits provided in an embodiment of the present disclosure;

FIG. 18 is a schematic cross-sectional view taken along an F3F4 direction in FIG. 17;

FIG. 19 is a schematic diagram of a third layout of sub-pixel driving circuits provided in an embodiment of the present disclosure;

FIG. 20 is a schematic cross-sectional view taken along an F5F6 direction in FIG. 19;

FIG. 21 is a schematic diagram of a fourth layout of a sub-pixel driving circuit provided in an embodiment of the present disclosure;

FIG. 22 is a schematic diagram of a layout of a light shielding layer provided in an embodiment of the present disclosure;

FIG. 23 is a schematic cross-sectional view taken along an F7F8 direction in FIG. 21;

FIG. 24 is a schematic diagram of a fifth layout of a sub-pixel driving circuit provided in an embodiment of the present disclosure;

FIG. 25 is a schematic layout diagram of a first source drain metal layer in FIG. 24;

FIG. 26 is a schematic diagram of a third layout of an active layer of a sub-pixel driving circuit provided in an embodiment of the present disclosure;

FIG. 27 is a layout diagram of adding a first gate metal layer on the basis of FIG. 26;

FIG. 28 is a layout diagram of adding a second gate metal layer on the basis of FIG. 27;

FIG. 29 is a schematic diagram of a layout of via holes in a case where a first source drain metal layer and an intermediate insulation layer are added on the basis of FIG. 28;

FIG. 30 is a schematic layout diagram of a layout of via holes in a case where a second source drain metal layer and a first planarization layer are added on the basis of FIG. 29;

FIG. 31 is a schematic diagram of the layout of the via holes the second source drain metal layer and the first planarization layer added in FIG. 30;

FIG. 32 is a schematic diagram of a fourth layout of an active layer of a sub-pixel driving circuit provided in an embodiment of the present disclosure;

FIG. 33 is a schematic diagram of a fifth layout of an active layer of a sub-pixel driving circuit provided in an embodiment of the present disclosure; and

FIG. 34 is a schematic diagram of a layout of data lines and data line leads provided in an embodiment of the present disclosure.

## DETAILED DESCRIPTION

In order to further illustrate a display substrate, a method for driving the same, and a display device provided in embodiments of the present disclosure, a detailed description will be provided below in conjunction with the accompanying drawings of the specification.

An embodiment of the present disclosure provides a display substrate. The display substrate includes a plurality of sub-pixels, where the sub-pixel includes a sub-pixel driving circuit and a light-emitting element that are coupled to each other.

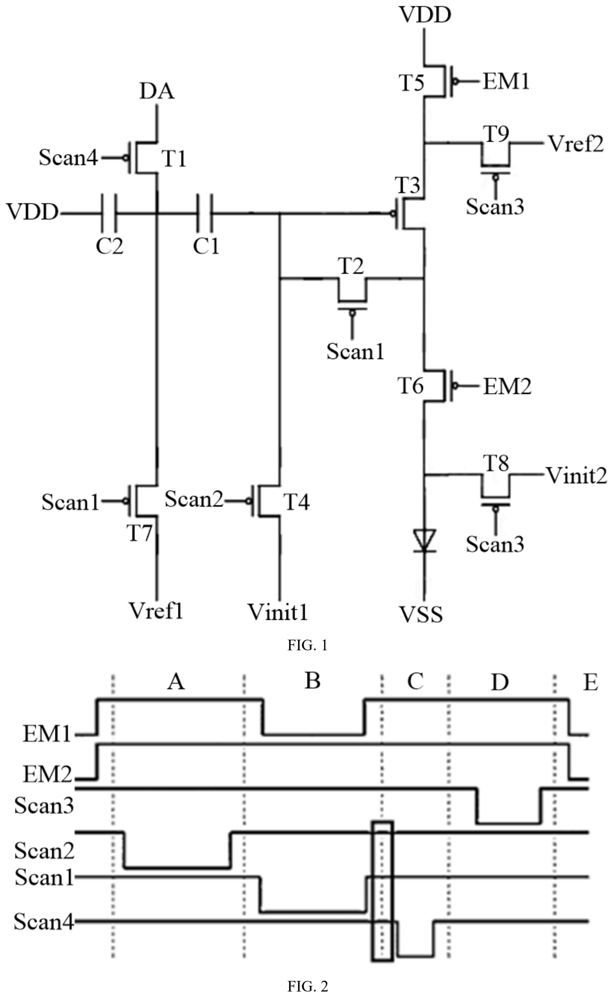

As shown in FIG. 1, for example, the sub-pixel driving circuit adopts a 9T2C circuit structure (including 9 transistors and 2 capacitors), but is not limited thereto.

The display substrate further includes: a first reference signal line Vrefl, a second reference signal line Vref2, a first initialization signal line Vinit1, a second initialization signal line Vinit2, a power supply line VDD, a data line DA, a first light-emission control signal line EM1, a second light-emission control signal line EM2, a first scan line Scan1, a second scan line Scan2, a third scan line Scan3, and a fourth scan line Scan4.

The 9T2C circuit structure includes: a data writing transistor T1, a first compensation transistor T2, a driving transistor T3, a first reset transistor T4, a power supply control transistor T5, a light-emission control transistor T6, a second reset transistor T7, a third reset transistor T9, a fourth reset transistor T8, a first capacitor C1, and a second capacitor C2.

A gate electrode of the data writing transistor T1 is coupled to the corresponding fourth scan line Scan4, a first electrode of the data writing transistor T1 is coupled to the corresponding data line DA, and a second electrode of the data writing transistor T1 is coupled to a second plate C12 of the first capacitor C1.

A gate electrode of the first compensation transistor T2 is coupled to the corresponding first scan line Scan1, a first electrode of the first compensation transistor T2 is coupled to a second electrode of the driving transistor T3, and a second electrode of the first compensation transistor T2 is coupled to a gate electrode T3-g (N1 node) of the driving transistor T3.

A gate electrode of the first reset transistor T4 is coupled to the corresponding second scan line Scan2, a first electrode of the first reset transistor T4 is coupled to the corresponding first initialization signal line Vinit1, and a second electrode of the first reset transistor T4 is coupled to the gate electrode T3-g of the driving transistor T3.

A gate electrode of the power supply control transistor T5 is coupled to the corresponding first light-emission control signal line EM1, a first electrode of the power supply control transistor T5 is coupled to the corresponding power supply line VDD, and a second electrode of the power supply control transistor T5 is coupled to the first electrode of the driving transistor T3.

A gate electrode of the light-emission control transistor T6 is coupled to the corresponding second light-emission control signal line EM2, a first electrode of the light-emission control transistor T6 is coupled to the second electrode of the driving transistor T3, and a second electrode of the light-emission control transistor T6 is coupled to the anode of the light-emitting element.

A gate electrode of the second reset transistor T7 is coupled to the corresponding first scan line Scan1, a first electrode of the second reset transistor T7 is coupled to the corresponding first reference signal line Vrefl, and a second electrode of the second reset transistor T7 is coupled to the second plate C12 of the first capacitor C1.

A gate electrode of the third reset transistor T9 is coupled to the corresponding third scan line Scan3, a first electrode of the third reset transistor T9 is coupled to the corresponding second reference signal line Vref2, and a second electrode of the third reset transistor T9 is coupled to the first electrode of the driving transistor T3.

A gate electrode of the fourth reset transistor T8 is coupled to the corresponding third scan line Scan3, a first electrode of the fourth reset transistor T8 is coupled to the corresponding second initialization signal line Vinit2, and a second electrode of the fourth reset transistor T8 is coupled to the anode of the light-emitting element. The cathode of the light-emitting element is coupled to a negative power supply signal line VSS.

A first plate C11 of the first capacitor C1 is coupled to the gate electrode T3-g of the driving transistor T3, the second plate C12 of the first capacitor C1 is coupled to a first plate C21 of the second capacitor C2, and a second plate C22 of the second capacitor C2 is coupled to the corresponding power supply line VDD.

As shown in FIG. 2, a method for driving the sub-pixel driving circuit includes: a first reset stage A, a compensation stage B, a data writing stage C, a second reset stage D, and a light-emission stage E.

In the first reset stage A, a second scan signal transmitted by the second scan line Scan2 is at an effective level, and the first reset transistor T4 is turned on to reset the gate electrode T3-g of the driving transistor T3, so that a voltage value of the gate electrode T3-g of the driving transistor T3 is equal to a voltage value of a first initialization signal transmitted by the first initialization signal line Vinit1, and the driving transistor T3 is turned on.

In the compensation stage B, a first light-emission control signal transmitted by the first light-emission control signal line EM1 is at an effective level, the first scan signal transmitted by the first scan line Scan1 is at an effective level, and the second reset transistor T7, the compensation transistor, and the power supply control transistor T5 are all turned on. At this time, a voltage value of the second plate C12 of the first capacitor C1 is the same as a voltage value of a first reference signal transmitted by the first reference signal line Vrefl. In this stage, a power supply signal transmitted by the power supply line VDD is written into the gate electrode T3-g of the driving transistor T3. When the potential of the gate electrode T3-g of the driving transistor T3 becomes Vdd + Vth, the driving transistor T3 is turned off and the compensation is completed, where Vdd represents a voltage value of the power supply signal, and Vth represents a threshold voltage of the driving transistor T3.

In the data writing stage C, a fourth scan signal transmitted by the fourth scan line Scan4 is at an effective level, and the data writing transistor T1 is turned on. At this time, the voltage value of the second plate C12 of the first capacitor C1 becomes Vdata, where Vdata represents a voltage value of a data signal transmitted by the data line DA. The voltage jump of the second plate C12 of the first capacitor C1 is Vdata - V1, where V1 represents the voltage value of the first reference signal, and the voltage of the gate electrode T3-g of the driving transistor T3 is Vdd + Vth + Vdata - V1.

In the second reset stage D, a third scan signal transmitted by the third scan line Scan3 is at an effective level, and the third reset transistor T9 and the fourth reset transistor T8 are turned on, to reset the first electrode of the driving transistor T3 and the anode of the light-emitting element.

In the light-emission stage E, a first light-emission control signal transmitted by the first light-emission control signal line EM1 is at an effective level, and a second light-emission control signal transmitted by the second light-emission control signal line EM2 is at an effective level. The power supply control transistor T5 and the light-emission control transistor T6 are both turned on, to cause the gate-source voltage Vgs of the driving transistor T3 to satisfy Vgs = Vth + Vdata - V1. The light-emitting element emits light and generates a leakage current of $\frac{k}{2}$ (Vdata - V1)$^2$.

Between the compensation stage and the data writing stage, there is a floating stage without signal writing (as shown in the solid box in FIG. 2). In this stage, no signal is written to the node N1, and the potential of the node N1 is easily disturbed by the data signal (for example, the data signal line may affect the potential of the node N1 by affecting the potential of the first capacitor C1), which is recorded in the node N1 and causes an impact to the display effect. More specifically, a conventional sub-pixel driving circuit does not have the above problem because fluctuations of the data signal in the whole emission cycle are recorded in the compensation process, and the integral of a change amount of the data signal has little effect on the potential of the node N1. In a separate circuit, the instantaneous changes in the data signal after compensation are recorded at the node N1, which has a significant impact.

To reduce the impact of the data signal on the potential of the node N1 in the floating stage, it is considered that a functional layer having a constant potential is arranged around the data line DA, so as to reduce the impact of the data signal jump on the node N1. However, the above method may increase the loading of the data line DA when reducing the impact of the data signal on the node N1, which causes the remote potential of the data line DA to decrease, thereby affecting the display uniformity of the display product.

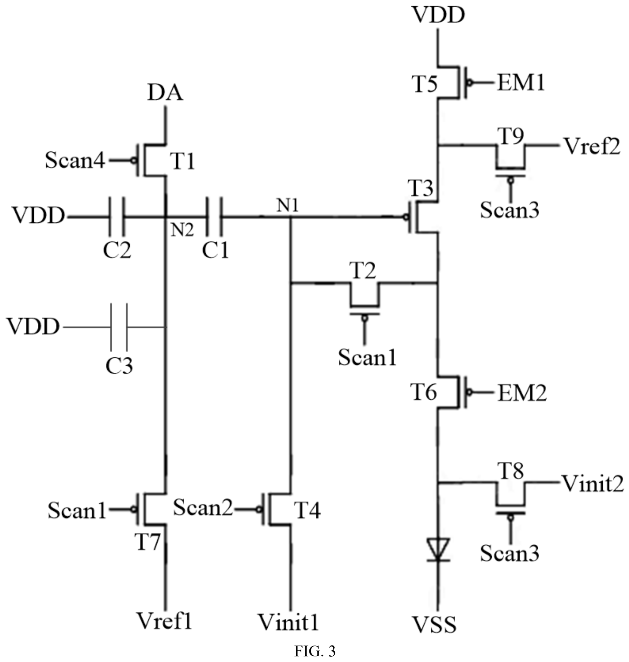

Referring to FIG. 3, and FIG. 7 to FIG. 16, an embodiment of the present disclosure provides a display substrate, which includes a base substrate, and a power supply line VDD, a data line DA, and a plurality of sub-pixels that are all arranged on the base substrate. The sub-pixel includes a sub-pixel driving circuit and a light-emitting element coupled to each other, and the sub-pixel driving circuit includes a driving transistor T3, a data writing transistor T1, a first capacitor C1, and a second capacitor C2.

A first plate C11 of the first capacitor C1 is coupled to a gate electrode T3-g of the driving transistor T3, a second plate C12 of the first capacitor C1 is coupled to a second electrode of the data writing transistor T1, and a first electrode of the data writing transistor T1 is coupled to the corresponding data line DA.

A first plate C21 of the second capacitor C2 is coupled to the second plate C12 of the first capacitor C1, and a second plate C22 of the second capacitor C2 is coupled to the corresponding power supply line VDD.

Among sub-pixel driving circuits located in a same row along a first direction, second plates C22 of second capacitors C2 included in the sub-pixel driving circuits are arranged in sequence along the first direction, there is a spacing region J1 between second plates C22 of adjacent second capacitors C2, and an orthographic projection of the data line DA onto the base substrate at least partially overlaps an orthographic projection of the spacing region J1 onto the base substrate.

For example, the display substrate includes multiple sub-pixels, and the driving circuits of the multiple sub-pixels are arranged in an array. The multiple sub-pixel driving circuits are divided into multiple rows of sub-pixel driving circuits and multiple columns of sub-pixel driving circuits. The multiple rows of sub-pixel driving circuits are arranged along a second direction, and each row of sub-pixel driving circuits includes multiple sub-pixel driving circuits arranged along the first direction. The multiple columns of sub-pixel driving circuits are arranged along the first direction, and each column of sub-pixel driving circuit includes multiple sub-pixel driving circuits arranged along the second direction. Exemplarily, the first direction intersects with the second direction. For example, the first direction includes the transverse direction, and the second direction includes the longitudinal direction.

For example, the sub-pixel includes the sub-pixel driving circuit and the light-emitting element. The sub-pixel driving circuit is coupled to an anode of the light-emitting element, to provide a driving signal for the light-emitting element and drive it to emit light.

For example, the display substrate includes multiple power supply lines VDD and multiple data lines DA. The multiple power supply lines VDD are arranged in sequence along the first direction, and the power supply line VDD includes at least a portion extending along the second direction. The multiple data lines DA are arranged along the first direction, and the data line DA includes at least a portion extending along the second direction.

For example, the multiple power supply lines VDD correspond to multiple columns of sub-pixel driving circuits in one-to-one manner, and each of the power supply lines VDD is coupled to each sub-pixel driving circuit in one corresponding column of sub-pixel driving circuits. The multiple data lines DA correspond to multiple columns of sub-pixel driving circuits in one-to-one manner, and each of the data lines DA is coupled to each sub-pixel driving circuit in one corresponding column of sub-pixel driving circuits.

For example, an orthographic projection of the first plate C11 of the first capacitor C1 onto the base substrate overlaps at least partially with an orthographic projection of the second plate C12 of the first capacitor C1 onto the base substrate. An orthographic projection of the first plate C21 of the second capacitor C2 onto the base substrate overlaps at least partially with an orthographic projection of the second plate C22 of the second capacitor C2 onto the base substrate.

For example, the first plate C11 of the first capacitor C1 is reused as the gate electrode T3-g of the driving transistor T3, but not limited thereto.

For example, a width of the spacing region J1 along the second direction is smaller than or equal to a width of the second plate C22 of the second capacitor C2.

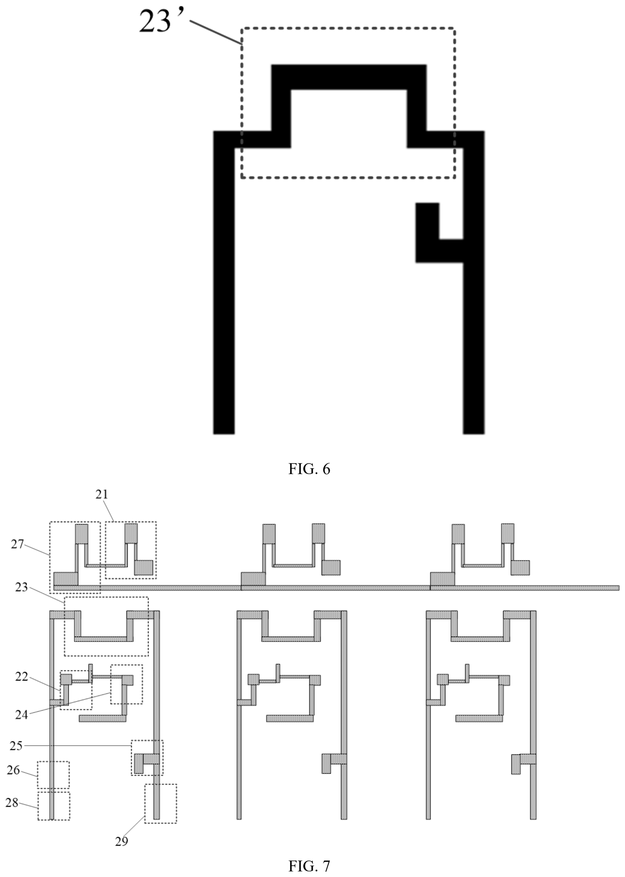

As an example, as shown in FIG. 6 and FIG. 7, FIG. 6 illustrates a layout diagram of a driving active layer 23' included in the driving transistor T3 in the related art; and FIG. 7 illustrates a layout diagram of a driving active layer 23 included in the driving transistor T3 in the present application. By comparison, it is found that the driving active layer 23 in the present application protrudes towards a light-emission control active layer 26 and a power supply control active layer 25, which is beneficial for reducing the overall layout space occupied by the active layer in the sub-pixel driving circuit, thereby facilitating the development of high-resolution display substrate.

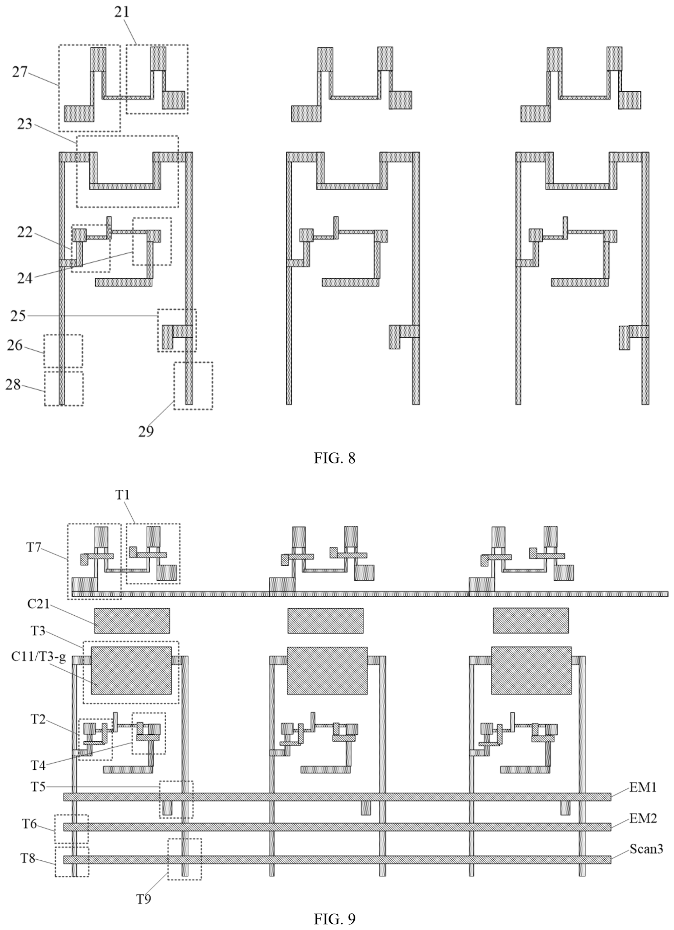

Exemplarily, as shown in FIG. 7 and FIG. 8, in FIG. 7, ends of the second reset active layers 27 (coupled to the first reference signal line) included in sub-pixel driving circuits located in the same row along the first direction are formed as an integrated structure. This arrangement can reduce the number of connection via holes used to connect the first reference signal line and one end of the second reset active layer 27, thereby reducing the layout space occupied by the sub-pixel driving circuit. In FIG. 8, the second reset active layers 27 included in the sub-pixel driving circuits located in the same row along the first direction are independent of each other. This arrangement allows one end of each second reset active layer 27 to be connected to the first reference signal line through a connection via hole.

For example, as shown in FIG. 3 and FIG. 12 to FIG. 14, a parasitic capacitance C3 is formed between a second conductive connection part 32 and the power supply line VDD, which greatly improves the stability of the second conductive connection part 32 and structures coupled to it.

According to the specific structure of the display substrate described above, it can be seen that in the display substrate provided in the embodiments of the present disclosure, a functional layer with a constant potential is arranged around the data line DA to reduce the impact of the jump of the data signal onto the node N1, and it is designed that the orthographic projection of the data line DA onto the base substrate at least partially overlaps the orthographic projection of the spacing region J1 onto the base substrate, which decreases an overlapping area between the orthographic projection of the data line DA onto the base substrate and the orthographic projection of the second plate C22 of the second capacitor C2 onto the base substrate. In this way, the loading of the data line DA can be reduced while reducing the impact of the data signal onto the node N1, and this avoids a decrease in the remote potential of the data line DA, thereby ensuring the uniformity of the display product.

As shown in FIG. 9 to FIG. 16, in some embodiments, the second plates C22 of the adjacent second capacitors C2 along the first direction are coupled to each other through a plate connection part 10. The spacing region J1 and the plate connection part 10 are arranged along the second direction between the second plates C22 of the adjacent second capacitors C2, and the first direction intersects the second direction. The orthographic projection of the data line DA onto the base substrate overlaps at least partially with an orthographic projection of the plate connection part 10 onto the base substrate.

For example, the plate connection part 10 and the second plate C22 of the second capacitor C2 coupled to the plate connection part are formed as an integrated structure, which are not limited thereto.

For example, the larger the width of the portion of the plate connection part 10 located between the second plates C22 of adjacent second capacitors C2 along the first direction, the smaller the width of the spacing region J1 along the first direction; the smaller the width of the portion of the plate connection part 10 located between the second plates C22 of adjacent second capacitors C2 along the first direction, the larger the width of the spacing region J1 along the first direction.

In the display substrate provided in the above embodiments, the second plate C22 of the second capacitor C2 is coupled to the power supply line VDD, and the second plates C22 of the adjacent second capacitors C2 in the first direction are connected together through the plate connection part 10, so that the second plates C22 of the second capacitors C2 and the power supply line VDD can form a grid structure. This grid structure is used to transmit a power supply signal with a stable potential, which is conducive to reducing the loading of the power supply line VDD thereby improving the uniformity of the power supply signal.

As shown in FIG. 7 to FIG. 16, in some embodiments, the display substrate further includes a first initialization signal line Vinit1; the sub-pixel driving circuit further includes a first compensation transistor T2 and a first reset transistor T4; a first electrode of the first compensation transistor T2 is coupled to the second electrode of the driving transistor T3, and a second electrode of the first compensation transistor T2 is coupled to the gate electrode T3-g of the driving transistor T3; a first electrode of the first reset transistor T4 is coupled to the corresponding first initialization signal line Vinit1, and a second electrode of the first reset transistor T4 is coupled to the gate electrode T3-g of the driving transistor T3. The first compensation transistor T2 includes a first compensation active layer 22, and the first reset transistor T4 includes a first reset active layer 24.

The plate connection part 10 includes a connection body portion 101 and a connection extension portion 102 that are coupled to each other. The connection body portion 101 is coupled to the second plates C22 of the adjacent second capacitors C2. An orthographic projection of the connection extension portion 102 onto the base substrate at least partially overlaps an orthographic projection of the first compensation active layer 22 onto the base substrate included in one of two adjacent sub-pixel driving circuits along the first direction, and/or at least partially overlaps an orthographic projection of the first reset active layer 24 onto the base substrate included in the other one of two adjacent sub-pixel driving circuits along the first direction.

For example, the first compensation active layer 22 includes two first compensation channel portions, and first compensation conductor portions respectively coupled to the two first compensation channel portions; the first reset active layer 24 includes two first reset channel portions, and first reset conductor portions respectively coupled to the two first reset channel portions. The orthographic projection of the connection extension portion 102 onto the base substrate at least partially overlaps orthographic projections of the first compensation conductor portions onto the base substrate included in one of two adjacent sub-pixel driving circuits along the first direction, and/or at least partially overlaps orthographic projections of the first reset conductor portions onto the base substrate included in the other one of two adjacent sub-pixel driving circuits along the first direction.

In the display substrate provided in the above embodiments, each of the first compensation transistor T2 and the first reset transistor T4 includes a double-gate transistor, and the connection extension portion 102 can block the corresponding conductor portions included in the first compensation transistor T2 and/or the first reset transistor T4, thereby ensuring the operational stability of the first compensation transistor T2 and/or the first reset transistor T4.

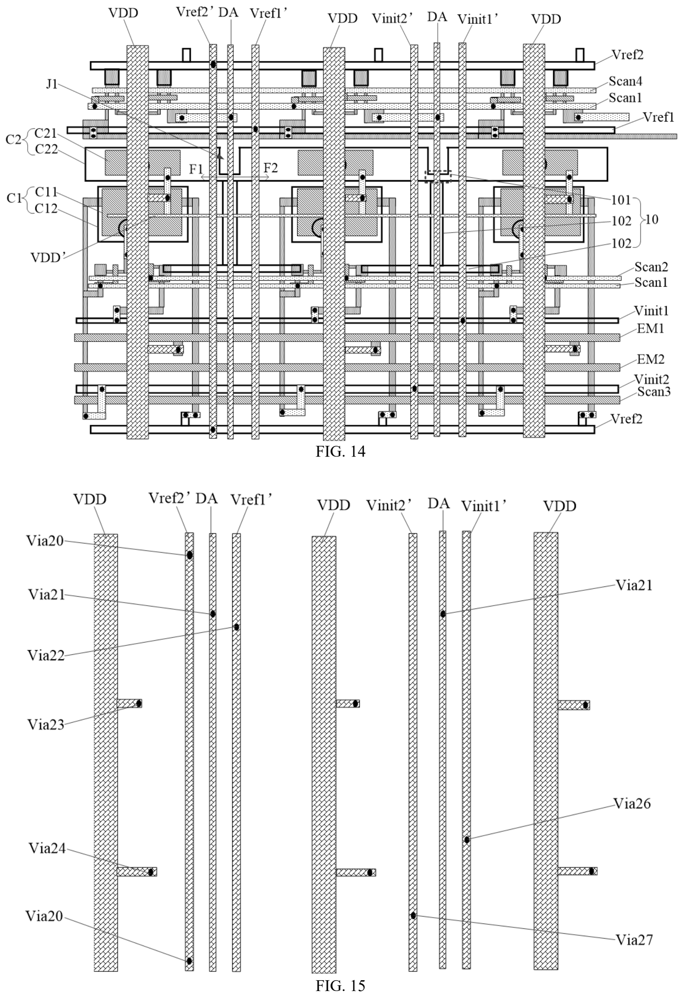

As shown in FIG. 14, in some embodiments, it is arranged that the orthographic projection of the data line DA onto the base substrate at least partially overlaps an orthographic projection of the connection body portion 101 onto the base substrate; and/or, the orthographic projection of the data line DA onto the base substrate at least partially overlaps the orthographic projection of the connection extension portion 102 onto the base substrate.

For example, the connection body portion 101 and the connection extension portion 102 are formed as an integrated structure, and the connection body portion 101 located between second plates C22 of adjacent second capacitors C2.

Since both the connection body portion 101 and the connection extension portion 102 have the stable potential, the above arrangement is beneficial in reducing the impact of the jump of the data signal on the node N1. At the same time, by setting a spacing region J1 between the second plates C22 of adjacent second capacitors C2, the orthographic projection of the data line DA onto the base substrate overlaps at least partially with the orthographic projection of the spacing region J1 onto the base substrate, which achieves a reduction in the loading of the data line DA while reducing the impact of the data signal on the node N1, thereby avoiding a decrease in the remote potential of the data line DA and ensuring the display uniformity of the display product.

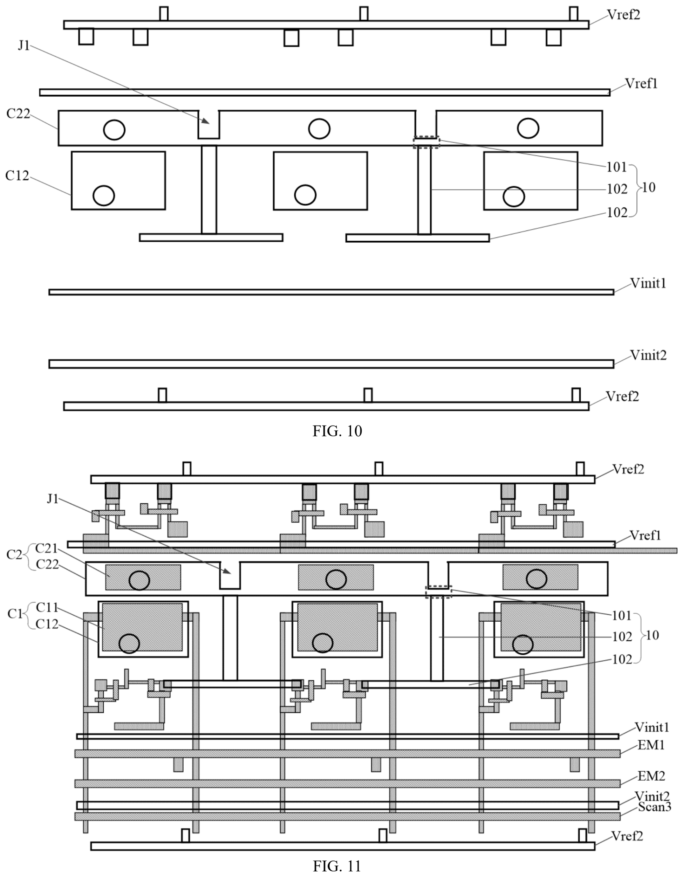

As shown in FIG. 10 to FIG. 15, in some embodiments, the display substrate further includes multiple first reference signal connection lines Vref1' and multiple second reference signal connection lines Vref2'. The first reference signal connection lines Vref1' and second reference signal connection lines Vref2' are alternately arranged along the first direction. An orthographic projection of at least portion of the data line DA onto the base substrate is located between orthographic projections of the first reference signal connection line Vref1' and the second reference signal connection line Vref2' onto the base substrate that are adjacent.

Exemplarily, the first reference signal connection line Vref1' is used to transmit a first reference signal having a stable voltage, and the second reference signal connection line Vref2' is used to transmit a second reference signal having a stable voltage.

Exemplarily, the multiple first reference signal connection lines Vref1 'are arranged along the first direction, and the first reference signal connection line Vref1' includes at least a portion extending along the second direction. The multiple second reference signal connection lines Vref2' are arranged along the first direction, and the second reference signal connection line Vref2' includes at least a portion extending along the second direction.

In the display substrate provided by the above embodiments, by arranging that the orthographic projection of at least portion of the data line DA onto the base substrate is located between orthographic projections of the first reference signal connection line Vref1' and the second reference signal connection line Vref2' onto the base substrate that are adjacent, signal lines for transmitting stable signals are arranged on both sides of the data line DA, which is beneficial for reducing the impact of data signal jumps on the node N1.

For example, the data line DA is arranged on a same layer as the first reference signal connection line Vref1'; or, the data line DA and the first reference signal connection line Vrefl' are arranged in different layers.

For example, the data line DA is arranged on a same layer as the second reference signal connection line Vref'; or, the data line DA and the second reference signal connection line Vref2' are arranged in different layers.

For example, the data line DA and the first reference signal connection line Vref1' are arranged in different layers; and/or, the data line DA and the second reference signal connection line Vref2' are arranged in different layers.

The above arrangement manner can achieve a flexible layout of the first reference signal connection line Vref1' and the second reference signal connection line Vref2' and reduce the impact of data signal jumps on the node N1, thereby effectively reducing the layout difficulty of the display substrate.

As shown in FIG. 10 to FIG. 15, in some embodiments, the display substrate further includes multiple first reference signal lines Vrefl 1; and the sub-pixel driving circuit further includes a second reset transistor T7. The first electrode of the second reset transistor T7 is coupled to the corresponding first reference signal line Vrefl, and the second electrode of the second reset transistor T7 is coupled to the second plate C12 of the first capacitor C1. The first reference signal connection lines Vref1' are coupled to multiple first reference signal lines Vrefl, respectively.

For example, the multiple first reference signal lines Vrefl are arranged along the second direction, and the first reference signal line Vrefl includes at least a portion extending along the first direction. The multiple first reference signal lines Vrefl correspond to multiple rows of sub-pixel driving circuits in one-to-one manner, and each of the first reference signal lines Vrefl is coupled to each sub-pixel driving circuit in a corresponding row of sub-pixel driving circuits.

In the above arrangement, the first reference signal connection lines Vref1' are coupled with the multiple first reference signal lines Vrefl, to enable the first reference signal connection lines Vref1' and the first reference signal lines Vrefl to form a grid structure, thereby reducing the loading of the first reference signal line Vrefl and ensuring the uniformity of the transmitted first reference signals.

As shown in FIG. 10 to FIG. 15, in some embodiments, the display substrate further includes multiple second reference signal lines Vref2; the sub-pixel driving circuit further includes a third reset transistor T9. The first electrode of the third reset transistor T9 is coupled to the corresponding second reference signal line Vref2, and the second electrode of the third reset transistor T9 is coupled to the first electrode of the driving transistor T3. The second reference signal connection lines Vref2' are coupled to multiple second reference signal lines Vref2, respectively.

For example, the multiple second reference signal lines Vref2 are arranged along the second direction, and the second reference signal line Vref2 includes at least a portion extending along the first direction. The multiple second reference signal lines Vref2 correspond to multiple rows of sub-pixel driving circuits in one-to-one manner, and each of the second reference signal lines Vref2 is coupled to each sub-pixel driving circuit in a corresponding row of sub-pixel driving circuits.

In the above arrangement, the second reference signal connection lines Vref2' are coupled with the multiple second reference signal lines Vref2, to enable the second reference signal connection lines Vref2' and the second reference signal lines Vref2 to form a grid structure, thereby reducing the loading of the second reference signal line Vref2 and ensuring the uniformity of the transmitted first reference signals.

As shown in FIG. 10 to FIG. 15, in some embodiments, the display substrate further includes multiple first initialization signal connection lines Vinit1' and multiple second initialization signal connection lines Vinit2'. The first initialization signal connection lines Vinit1' and the second initialization signal connection lines Vinit2' are alternately arranged along the first direction. The orthographic projection of at least portion of the data line DA onto the base substrate is located between orthographic projections of a first initialization signal connection line Vinit1' and a second initialization signal connection line Vinit2' that are adjacent onto the base substrate. The data line DA and the first initialization signal connection line Vinit1' are arranged in different layers; and/or, the data line DA and the second initialization signal connection line Vinit2' are arranged in different layers.

For example, the first initialization signal connection line Vinit1' is used to transmit a first initialization signal having a stable voltage, and the second initialization signal connection line Vinit2' is used to transmit a second initialization signal having a stable voltage.

For example, the multiple first initialization signal connection lines Vinit1' are arranged along the first direction, and the first initialization signal connection line Vinit1' includes at least a portion extending along the second direction. The multiple second initialization signal connection lines Vinit2' are arranged along the first direction, and the second initialization signal connection line Vinit2' includes at least a portion extending along the second direction.

In the display substrate provided by the above embodiments, it is arranged that orthographic projection of at least portion of the data line DA onto the base substrate is located between orthographic projections of a first initialization signal connection line Vinit1' and a second initialization signal connection line Vinit2' that are adjacent onto the base substrate, which sets signal lines for transmitting stable signals on both sides of the data line DA, and is beneficial for reducing the impact of the jump of the data signal on the node N1.

For example, the data line DA and the first initialization signal connection line Vinit1' are arranged in a same layer; or, the data line DA and the first initialization signal connection line Vinit1' are arranged in different layers.

For example, the data line DA and the second initialization signal connection line Vinit2' are arranged in a same layer; or, the data line DA and the second initialization signal connection line Vinit2' are arranged in different layers.

For example, the data line DA and the first initialization signal connection line Vinit1' are arranged in different layers; and/or, the data line DA and the second initialization signal connection line Vinit2' are arranged in different layers.

The above arrangement manner can achieve a flexible layout of the first initialization signal connection line Vinit1' and the second initialization signal connection line Vinit2', and reduce the impact of data signal jumps on the node N1, effectively reducing the layout difficulty of the display substrate.

As shown in FIG. 10 to FIG. 15, in some embodiments, the display substrate further includes multiple first initialization signal lines Vinit1; the sub-pixel driving circuit further includes a first reset transistor T4. A first electrode of the first reset transistor T4 is coupled to the corresponding first initialization signal line Vinit1, and a second electrode of the first reset transistor T4 is coupled to the gate electrode T3-g of the driving transistor T3. The first initialization signal connection lines Vinit1' are coupled to multiple first initialization signal lines Vinit1, respectively.

For example, the multiple first initialization signal lines Vinit1 are arranged along the second direction, and the first initialization signal line Vinit1 includes at least a portion extending along the first direction. The multiple first initialization signal lines Vinit1 correspond to multiple rows of sub-pixel driving circuits in one-to-one manner, and each of the first initialization signal lines Vinit1 is coupled to each sub-pixel driving circuit in a corresponding row of sub-pixel driving circuits.

In the above arrangement, the first initialization signal connection lines Vinit1' and multiple first initialization signal lines Vinit1 are coupled, to enable the first initialization signal connection lines Vinit1' and multiple first initialization signal lines Vinit1 to form a grid structure, thereby reducing the loading of the first initialization signal line Vinit1 and ensuring the uniformity of the transmitted first initialization signal.

As shown in FIG. 10 to FIG. 15, in some embodiments, the display substrate further includes multiple second initialization signal lines Vinit2; the sub-pixel driving circuit further includes a fourth reset transistor T8. A first electrode of the fourth reset transistor T8 is coupled to a corresponding one of the second initialization signal lines Vinit2, and a second electrode of the fourth reset transistor T8 is coupled to the anode of the light-emitting element. The second initialization signal connection lines Vinit2' are coupled to multiple second initialization signal lines Vinit2, respectively.

For example, the multiple second initialization signal lines Vinit2 are arranged along a second direction, and the second initialization signal line Vinit2 includes at least a portion extending along the first direction. The multiple second initialization signal lines Vinit2 correspond to multiple rows of sub-pixel driving circuits in one-to-one manner, and each of the second initialization signal lines Vinit2 is coupled to each sub-pixel driving circuit in a corresponding row of sub-pixel driving circuits.

In the above arrangement, the second initialization signal connection lines Vinit2' are coupled with multiple second initialization signal lines Vinit2, to enable the second initialization signal connection line Vinit2' and the second initialization signal line Vinit2 to form a grid structure, thereby reducing the loading of the second initialization signal line Vinit2 and ensuring the uniformity of the transmitted second initialization signal.

As shown in FIG. 10 to FIG. 15, in some embodiments, the multiple first reference signal connection lines Vref1' and the multiple second reference signal connection lines Vref2' are divided into multiple groups of reference signal connection lines arranged along the first direction, where each group of reference signal connection lines includes one first reference signal connection line Vref1' and one second reference signal connection line Vref2'. The multiple first initialization signal connection lines Vinit1' and the multiple second initialization signal connection lines Vinit2' are divided into multiple groups of initialization signal connection lines arranged along the first direction, which each group of initialization signal connection lines includes one first initialization signal connection line Vinit1' and one second initialization signal connection line Vinit2'. The group of reference signal connection lines and the group of initialization signal connection lines are alternately arranged along the first direction.

For example, some of the data lines DA in the display substrate correspond to multiple groups of reference signal connection lines, respectively, and the orthographic projection of the data line DA onto the base substrate is located between orthographic projections of the first reference signal connection line Vref1' and the second reference signal connection line Vref2' onto the base substrate, which are in a corresponding group of reference signal connection lines. For example, the other data lines DA in the display substrate correspond to multiple groups of initialization signal connection lines, respectively, and the orthographic projection of the data line DA onto the base substrate is located between orthographic projections of the first initialization signal connection line Vinit1' and the second initialization signal connection line Vinit2' onto the base substrate, which are in a corresponding group of initialization signal connection lines.

The above arrangement manner can achieve a more reasonable planning of the layout space of the display substrate while reducing the loading of the first reference signal line Vrefl, the second reference signal line Vref2, the first initialization signal line Vinit1, and the second initialization signal line Vinit2, thereby reducing the layout difficulty of the display substrate.

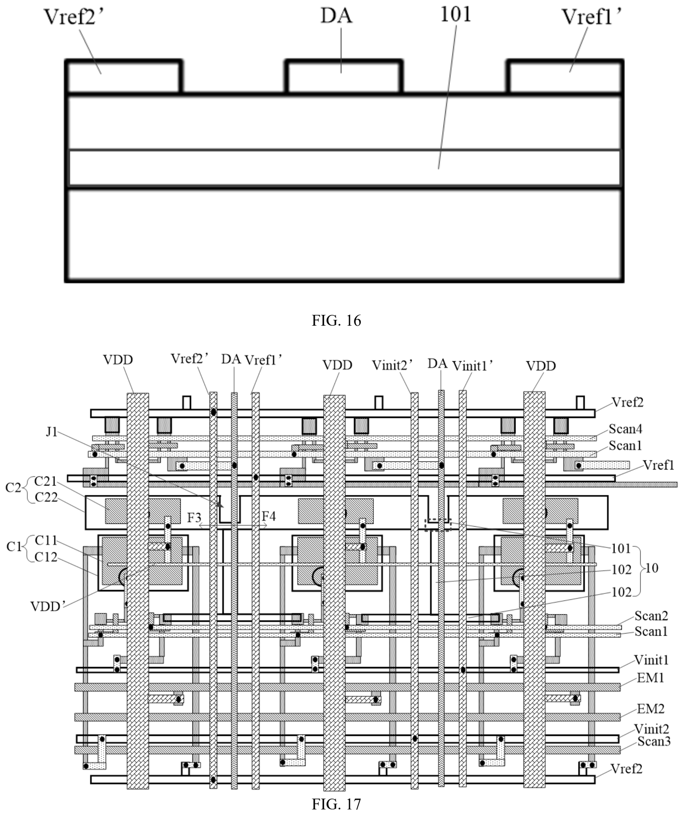

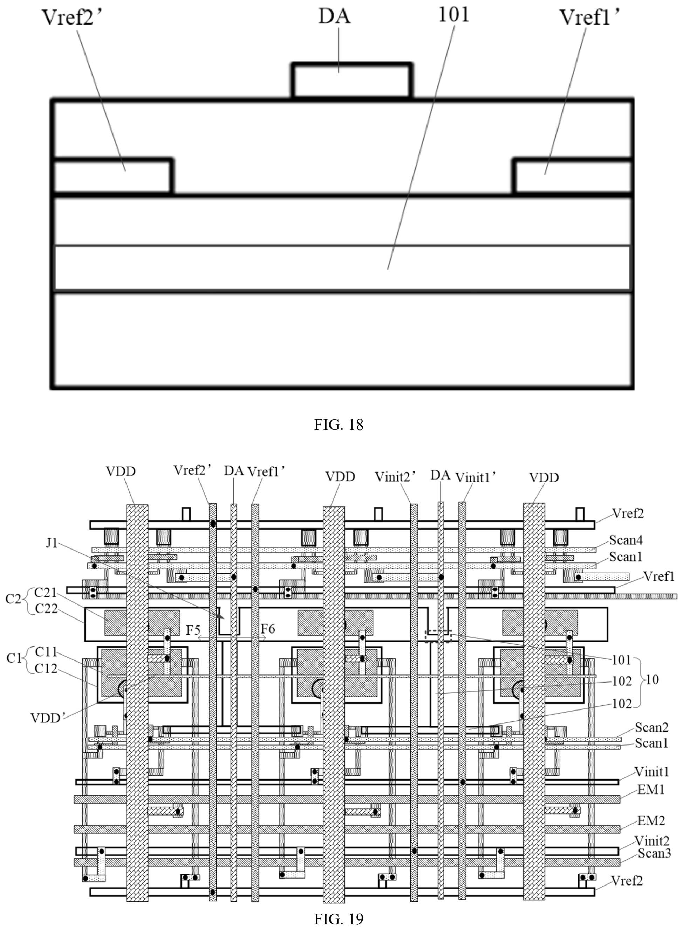

As shown in FIG. 17 and FIG. 18, in some embodiments, the display substrate includes a first source drain metal layer, a second source drain metal layer, and a third source drain metal layer stacked in sequence along a direction away from the base substrate.

The data lines DA and the third source drain metal layer are arranged in a same layer and fabricated by a same material. The first reference signal connection lines Vref', the second reference signal connection lines Vref', the first initialization signal connection lines Vinit1', and the second initialization signal connection lines Vinit2' are all arranged in a same layer and fabricated by a same material as the second source drain metal layer.

For example, the display substrate includes a light shielding layer LS, an insulation layer, an active layer, a first gate insulation layer, a first gate metal layer, a second gate insulation layer, a second gate metal layer, an intermediate insulation layer, a first source drain metal layer, a first planarization layer, a second source drain metal layer, a second planarization layer, a third source drain metal layer, a third planarization layer, an anode layer, a light-emitting functional layer, a cathode layer, a first inorganic encapsulation layer, an organic encapsulation layer, and a second inorganic encapsulation layer, which are sequentially stacked in a direction away from the base substrate. The display substrate may also include a passivation layer, but is not limited thereto.

In the above setting manner, the data line DA can be formed simultaneously with the third source drain metal layer in a same patterning process; the first reference signal connection line Vref', the second reference signal connection line Vref', the first initialization signal connection line Vinit1', and the second initialization signal connection line Vinit2' can all be formed simultaneously with the second source drain metal layer in a same patterning process, which effectively simplifies the manufacturing process of the display substrate and reduces the production cost of the display substrate. Moreover, the above setting manner enable a distance between the data line DA and the node N1 to be farther, which can better shield the impact of data signal jumps on the node N1.

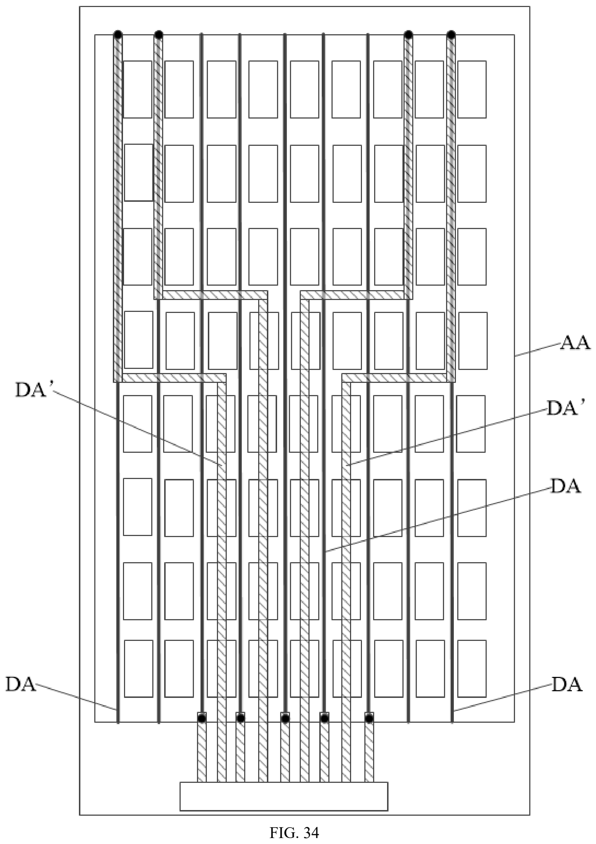

As shown in FIG. 34, in some embodiments, the display substrate further includes multiple data line leads DA'; the display substrate includes multiple data lines DA arranged along the first direction, which are divided into a first group of data lines, a second group of data lines, and a third group of data lines arranged along the first direction.

The data line DA in the first group of data lines is coupled to a corresponding one of the data line leads DA', and the data line lead DA' extends from a position where it is coupled to the data line DA to a middle area of the display substrate, and extends from the middle area to a bottom border area of the display substrate.

The data line DA in the third group of data lines is coupled to a corresponding one of the data line leads DA', and the data line lead DA' extends from a position where it is coupled to the data line DA to the middle area, and extends from the middle area to the bottom border area.

For example, the data line lead DA' and the data line DA are arranged in different layers.

For example, the display substrate includes a display area and a peripheral area around the display area, where the peripheral area includes an upper border area, a lower border area, a left border area, and a right border area. The first group of data lines is located near the left border area, and the third group of data lines is located near the right border area.

In the above arrangement method, the data lines DA near the left border area and the right border area of the display substrate are coupled to a driving chip in the display substrate through the data line leads DA', which avoids direct extension of the data lines DA near the left border area and the right border area of the display substrate to the lower border area through fan lines, thereby effectively narrowing the width of the lower border area of the display substrate.

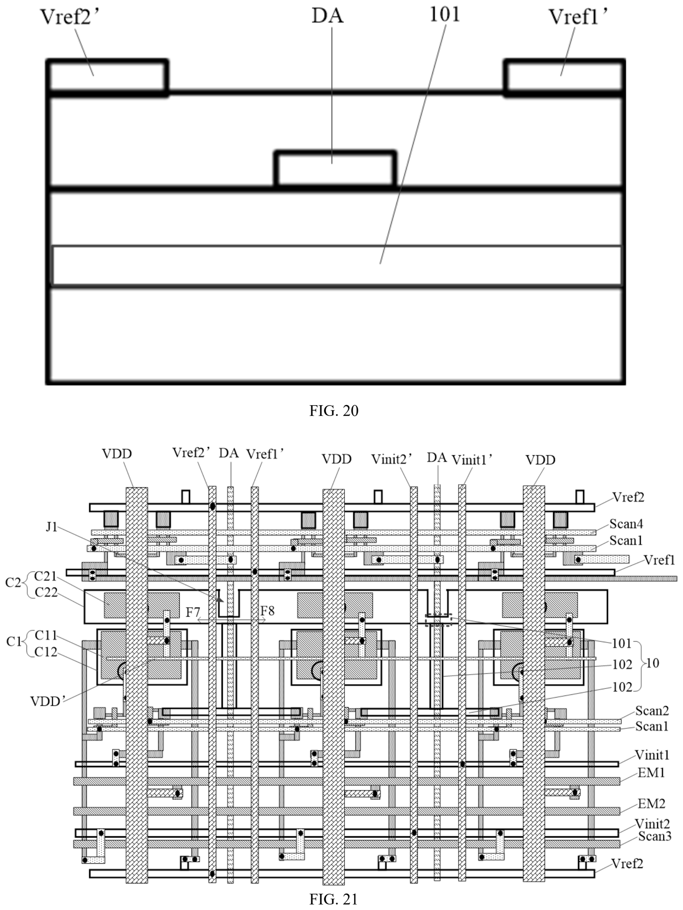

As shown in FIG. 19 and FIG. 20, in some embodiments, the display substrate includes a first source drain metal layer, a second source drain metal layer, and a third source drain metal layer stacked in sequence along a direction away from the base substrate.

The data lines DA and the second source drain metal layer are arranged in a same layer and fabricated by a same material, and the first reference signal connection lines Vref', the second reference signal connection lines Vref', the first initialization signal connection lines Vinit1', and the second initialization signal connection lines Vinit2' are all arranged in a same layer and fabricated by a same material as the third source drain metal layer.

In the above arrangement manner, the data lines DA can be formed simultaneously with the second source drain metal layer in a same patterning process; the first reference signal connection line Vref1', the second reference signal connection line Vref', the first initialization signal connection line Vinit1', and the second initialization signal connection line Vinit2' can all be formed simultaneously with the third source drain metal layer in a same patterning process, which effectively simplifies the manufacturing process of the display substrate and reduces the production cost of the display substrate.

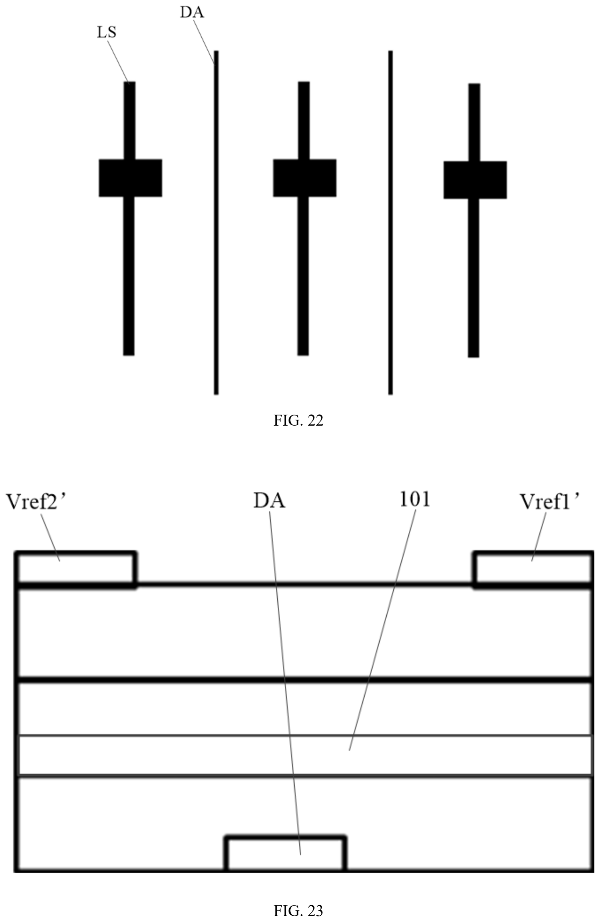

As shown in FIG. 21 to FIG. 23, in some embodiments, the display substrate includes a light shielding layer LS, a first source drain metal layer, a second source drain metal layer, and a third source drain metal layer stacked in sequence along a direction away from the base substrate.

The data lines DA are arranged in a same layer and made of a same material as the light shielding layer LS. The first reference signal connection line Vref', the second reference signal connection line Vref', the first initialization signal connection line Vinit1', and the second initialization signal connection line Vinit2' are all arranged in a same layer and made of a same material as the second source drain metal layer.

For example, the light shielding layer LS is also used to shield the driving transistor T3, achieving the effect of stabilizing the driving transistor T3.

In the above arrangement method, the data lines DA can be formed simultaneously with the light shielding layer LS in a same patterning process; the first reference signal connection line Vref', the second reference signal connection line Vref', the first initialization signal connection line Vinit1', and the second initialization signal connection line Vinit2' can all be formed simultaneously with the second source drain metal layer in a same patterning process, which effectively simplifies the manufacturing process of the display substrate, and reduces the production cost of the display substrate.

In the above arrangement method, the data line DA and the light shielding layer LS are arranged in the same layer and fabricated by the same material, which is beneficial for reducing the layout space occupied by subpixels, thereby improving the resolution of the display substrate.

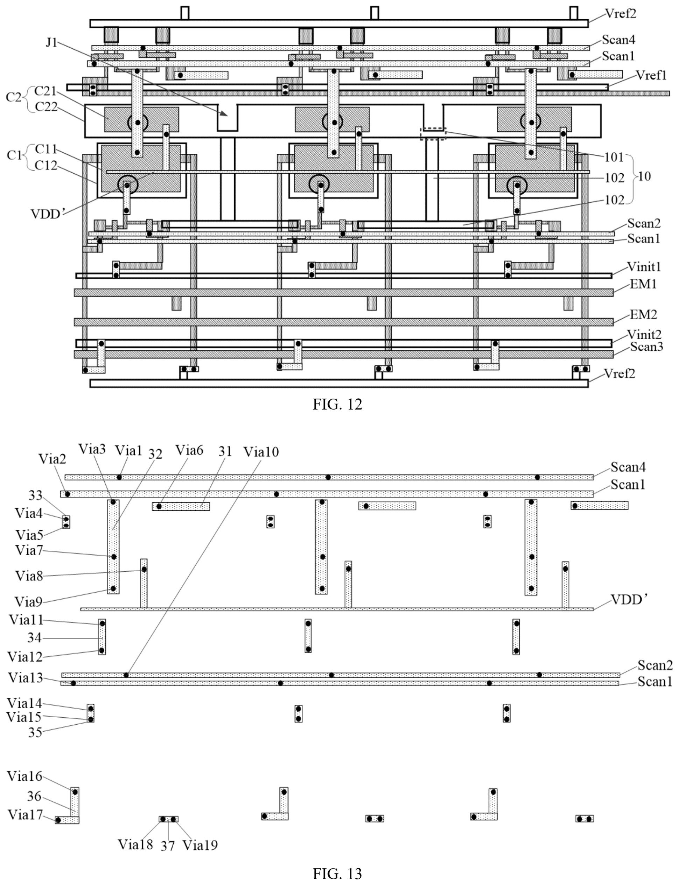

As shown in FIG. 13 to FIG. 15, in some embodiments, the display substrate further includes multiple power supply connection lines VDD'. The power supply connection line VDD' include at least a portion extending along the first direction. The power supply connection lines VDD' are coupled to the multiple power supply lines VDD.

For example, the power supply connection line VDD' is arranged in a same layer and fabricated by a same material as the first source drain metal layer, but not limited thereto.

For example, the multiple power supply connection lines VDD' are arranged along the second direction.

The power supply connection line VDD' is coupled to multiple power supply lines VDD, so that the power supply connection lines VDD' and the power supply lines can form a grid structure, thereby reducing the loading of the power supply line VDD and improving the uniformity of the power supply signal.

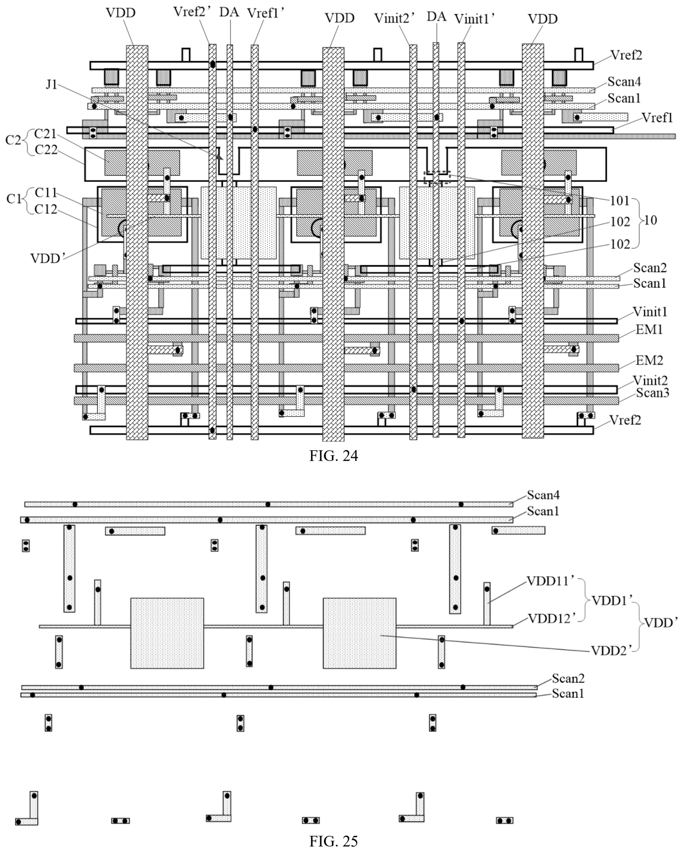

As shown in FIG. 24 and FIG. 25, in some embodiments, the power supply connection line VDD' includes multiple first power supply portions VDD1' and multiple second power supply portions VDD2', which are alternately arranged along the first direction.

The first power supply portion VDD1' includes a first sub-portion VDD11' and a second sub-portion VDD12'. The first sub-portion VDD11' is coupled to the second sub-portion VDD12' and the power supply line VDD. The second sub-portion VDD12' and the second power supply portion VDD2' that are adjacent are coupled to each other. A width of the second power supply portion VDD2' along the second direction is greater than that of the second sub-portion VDD12' along the second direction. An orthographic projection of the second power supply portion VDD2' onto the base substrate overlaps at least partially with the orthographic projection of the data line DA onto the base substrate.

For example, the first power supply portion VDD1' and the second power supply portion VDD2' are formed as an integrated structure.

Exemplarily, the first sub-portion VDD11' extends along the second direction, but is not limited thereto.

In the above arrangement method, the power supply connection line VDD' near the overlapping area with the data line DA is widened, which further reduces the impact of the change of the data signal on the node N1. At the same time, the loading of the power supply line VDD is further reduced. Thus, the uniformity of the power supply signal is improved.

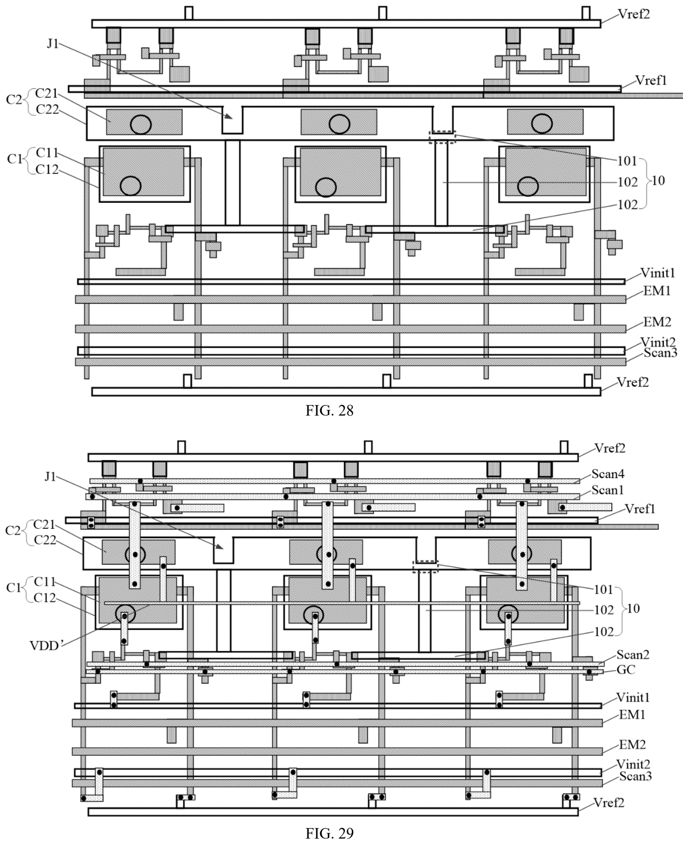

As shown in FIGs. 3 to 5, 26 to 31, in some embodiments, the sub-pixel further includes a first scan line Scan1 and a control signal line GC. The sub-pixel driving circuit further includes a first compensation transistor T2 and a second compensation transistor T10. The gate electrode of the first compensation transistor T2 is coupled to the corresponding first scan line Scan1, the first electrode of the first compensation transistor T2 is coupled to the second electrode of the driving transistor T3, and the second electrode of the first compensation transistor T2 is coupled to the gate electrode T3-g of the driving transistor T3. The gate electrode of the second compensation transistor T10 is coupled to the corresponding control signal line GC, the first electrode of the second compensation transistor T10 is coupled to the corresponding power supply line VDD, and the second electrode of the second compensation transistor T10 is coupled to the first electrode of the driving transistor T3.

For example, in the same sub-pixel driving circuit, the control signal line GC coupled to the gate electrode of the second compensation transistor T10 is reused as the first scan line Scan1 coupled to the gate electrode of the first compensation transistor T2.

To be more specific, the main reason why the change of the data signal affects the node N1 is the presence of a floating stage between the compensation stage and the data writing stage. If only the compensation time is increased, it is necessary to adjust a turned-on duration (i.e., an effective level duration) of the first light-emission control signal transmitted by the first light-emission control signal line EM1. This adjustment manner may easily increase the number of pulses of the first light-emission control signal, which may increase the loading of the first light-emission control signal and affect the sensitivity of the remote first light-emission control signal, resulting in uneven display.

In the display substrate provided by the above embodiments, a control signal line GC and a second compensation transistor T10 are added, and the control signal line GC is arranged to control the first compensation transistor T2 and the second compensation transistor T10. In the compensation stage, a control signal transmitted by the control signal line GC is at an effective level, and the control signal controls both the first compensation transistor T2 and the second compensation transistor T10 to be turned on. There is a first time interval t1 between a moment when the effective level of the control signal ends and a moment when the data writing transistor T1 is turned on, and t1 satisfies $t1 \leq m$, where m represents a first threshold. The above arrangement method enables the effective level of the control signal to cover the compensation stage and at least part of the floating stage, which mitigates the impact of the change of the data signal on the node N1. More specifically, the above arrangement method can extend the time of the compensation stage and shorten the time of the floating stage.

In the display substrate provided by the above embodiments, the influence of the change of the data signal on the node N1 is mitigated by adding the control signal line GC and the second compensation transistor T10, without the need to adjust the turned-on duration of the first light-emission control signal transmitted by the first light-emission control signal line EM1, thereby ensuring the turn-on sensitivity of the first light-emission control signal and ensuring the display uniformity of the display substrate.

It should be noted that in case of t1 ≤ m, t1 may take a negative value, which means that the compensation stage and the data writing stage can partially overlap. The value of the first threshold should meet the requirement of reducing the impact of the change of the data signal on node N1.

The transistor T10 is added, without adding an additional mask, which does not increase the process difficulty, and the same gate line is used by transistors T10 and T2 for control.

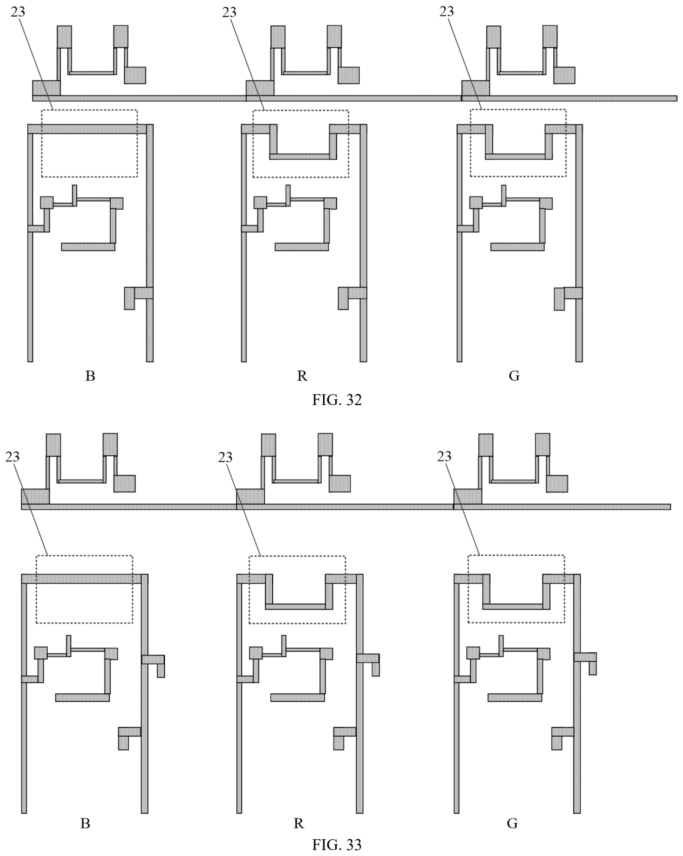

As shown in FIG. 32 and FIG. 33, in some embodiments, the multiple sub-pixels include a red sub-pixel R, a green sub-pixel G, and a blue sub-pixel B. The sub-pixel driving circuit in the red sub-pixel includes a driving transistor T3 with a first channel width-to-length ratio, the sub-pixel driving circuit in the green sub-pixel includes a driving transistor T3 with a second channel width-to-length ratio, and the sub-pixel driving circuit in the blue sub-pixel includes a driving transistor T3 with a third channel width-to-length ratio. It is designed that the third channel width-to-length ratio is greater than the first channel width-to-length ratio; and/or, the third channel width-to-length ratio is greater than the second channel width-to-length ratio.

Since the blue sub-pixel has the lower luminous efficiency than other sub-pixels, the above design manner enables the blue sub-pixel to have a larger driving current, effectively improving the brightness of blue sub-pixel and improving the uniformity of the display substrate.

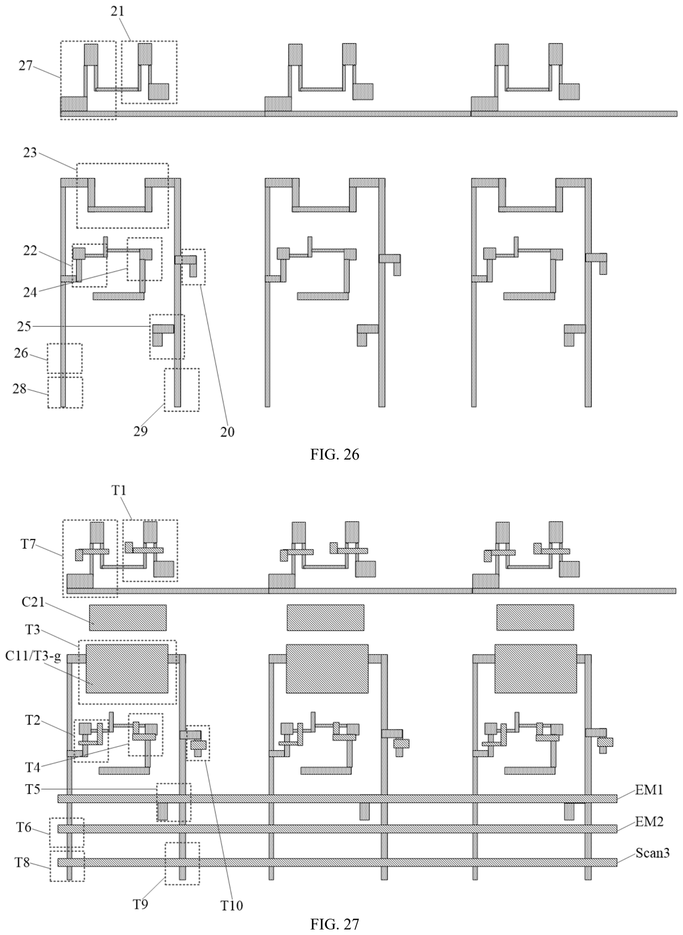

More specifically, FIG. 6 and FIG. 7 show a data writing active layer 21 included by the data writing transistor T1, a first compensation active layer 22 included by the first compensation transistor T2, a driving active layer 23 included by the driving transistor T3, a first reset active layer 24 included by the first reset transistor T4, a power supply control active layer 25 included by the power supply control transistor T5, a light-emission control active layer 26 included by the light-emission control transistor T6, a second reset active layer 27 included by the second reset transistor T7, a third reset active layer 29 included by the third reset transistor T9, and a fourth reset active layer 28 included by the fourth reset transistor T8. FIG. 26 shows a second compensation active layer 20 included by the second compensation transistor T10. For example, all the above active layers use low-temperature polycrystalline silicon (LTPS) active layers, but are not limited thereto.

For example, a driving active layer 23 included by the driving transistor T3 adopts an inverted ⊓⊔ shaped structure, and this channel design is beneficial for reducing the area occupied by sub-pixel driving circuits. For display products with the high refresh rate, an important application scenario is to reduce the size occupied by sub-pixel driving circuits. This design can improve the display resolution.

As shown in FIG. 9 and FIG. 27, the first gate metal layer is located on a side of the active layer away from the base substrate. In order to reduce leakage currents of the nodes N1 and N2 in the sub-pixel driving circuit, a double-gate LTPS transistor is adopted by each of the data writing transistor T1, the second reset transistor T7, the first compensation transistor T2, and the first reset transistor T4. In other embodiments, an oxide transistor may also be adopted by the data writing transistor T1, the second reset transistor T7, the first compensation transistor T2, and the first reset transistor T4. The gate electrodes of the data writing transistor T1, the second reset transistor T7, the first compensation transistor T2 and the first reset transistor T4 may be arranged in different layers from scan lines coupled to them. Since signals having the high alternating frequency are connected to these four transistors, in NoteBook-sized (NB-sized) display devices, the scan lines may be fabricated by a first source drain metal layer with lower resistivity, so as to reduce the loading caused by the change of the signal and improve the uniformity of NB-size display product. The material of the first gate metal layer includes Mo, but is not limited thereto.

It should be noted that in doping the active layer, the first gate metal layer may be used as a mask to achieve the doping process, or an independent mask layer may be formed, which is not limited here. Taking FIG. 9 as an example, the first light-emission control signal line EM1 and the second light-emission control signal line EM2 may form the power supply control transistor T5 and the light-emission control transistor T6 only together with the active layer, and may not form any other abnormal transistor. When using the first gate metal layer as a mask to achieve the doping process, in order to avoid forming the other abnormal transistor, a signal line located in an area where the abnormal transistor(s) may be formed as a jumper in the first source drain metal layer, to avoid the formation of the abnormal transistor(s).

As shown in FIGs. 10, 11 and 28, the first initialization signal line Vinit1, the second initialization signal line Vinit2, the first reference signal line Vrefl, and the second reference signal line Vref2 are all arranged in the second gate metal layer. Furthermore, both the second plate C12 and the second plate C22 are arranged on the second gate metal layer. The second plate C12 and the second plate C22 both include openings for exposing the first plate C11 and the first plate C21, so as to achieve a connection between the first plate C11 and the first source drain metal layer, and a connection between the first plate C21 and the first source drain metal layer. As shown in FIG. 9 and FIG. 11, the second reference signal line may include a covering portion for covering a conductive portion of the active layer between double gates of the data writing transistor T1 and the second reset transistor T7. This arrangement can reduce the leakage current of the dual-gate transistor and improve the stability of the transistor.

For example, a constant electrical signal is inputted to each of the first initialization signal line Vinit1, the second initialization signal line Vinit2, the first reference signal line Vrefl, and the second reference signal line Vref2. For example, a signal transmitted by each of the first initialization signal line Vinit1 and the second initialization signal line Vinit2 has a negative voltage, while a signal transmitted by each of the first reference signal line Vrefl and the second reference signal line Vref2 has a positive voltage.

For example, the second gate metal layer may adopt a Ti/Al/Ti stacked structure, which is beneficial for reducing the loading of NB-size display products.

As shown in FIGs. 12, 13, and 29, black dots in the figures represent via holes. The first scan line Scan1, the second scan line Scan2, and the fourth scan line Scan are all arranged in the first source drain metal layer, and in different layers from other signal lines, which is beneficial for solving the problem of a crosstalk between signal lines. Considering that each of the first scan line Scan1, the second scan line Scan2, and the fourth scan line Scan has a large loading in the process of a jump of a signal, the Ti/Al/Ti stacked structure adopted by the first source drain metal layer is conducive to relieving the problem of the large loading.

As shown in FIGs. 12, 13, and 29, the fourth scan line Scan4 is coupled to the gate electrode of the data writing transistor T1 through a first via hole Via1. The first scan line Scan1 is coupled to the gate electrode of the second reset transistor T7 through a second via hole Via2.

The second conductive connection part 32 is coupled to the second electrode of the data writing transistor T1 and the second electrode of the second reset transistor T7 through a third via hole Via3. The second conductive connection part 32 is coupled to the first plate C21 of the second capacitor C2 through a seventh via hole Via7. The second conductive connection part 32 is coupled to the second plate C12 of the first capacitor C1 through a ninth via hole Via9.

The third conductive connection part 33 is coupled to the first reference signal line Vrefl through a fourth via hole Via4. The third conductive connection part 33 is coupled to the first electrode of the second reset transistor T7 through a fifth via hole Via5.

The first conductive connection part 31 is coupled to the first electrode of the data writing transistor T1 through a sixth via hole Via6. As shown in FIG. 14 and FIG. 15, the first conductive connection part 31 is coupled to the data line DA through a twenty-first via hole Via21.

The power supply connection line VDD' is coupled to the second plate C22 of the second capacitor C2 through an eighth via hole Via8. The second scan line Scan2 is coupled to the gate electrode of the first reset transistor T4 through a tenth via hole Via10. The first scan line Scan1 is coupled to the gate electrode of the first compensation transistor T2 through a thirteenth via hole Via13.

A fourth conductive connection part 34 is coupled to the first plate C11 of the first capacitor C1 through an eleventh via hole Via11, and is coupled to the second electrode of the first compensation transistor T2 through a twelfth via hole Via12.

A fifth conductive connection part 35 is coupled to the first electrode of the first reset transistor T4 through a fourteenth via hole Via14. The fifth conductive connection part 35 is coupled to the first initialization signal line Vinit1 through a fifteenth via hole Via15.

A sixth conductive connection part 36 is coupled to the second initialization signal line Vinit2 through a sixteenth via hole Via16, and is coupled to the first electrode of the fourth reset transistor T8 through a seventeenth via hole Via17.

A seventh conductive connection part 37 is coupled to the second reference signal line Vref2 through an eighteenth via hole Via18, and is coupled to the first electrode of the third reset transistor T9 through a nineteenth via hole Via19.

As shown in FIG. 14 and FIG. 15, black dots in the figures represent via holes. The power supply line VDD is fabricated by a second source drain metal layer, which is used to shield the node N1 (corresponding to the fourth conductive connection part 34) and the node N2 (corresponding to the second fourth conductive connection part 32), so as to prevent voltage fluctuations between two nodes.

As shown in FIG. 14 and FIG. 15, the second reference signal connection line Vref2' is coupled to the second reference signal line Vref2 through a twentieth via hole Via20. The first reference signal connection line Vref1' is coupled to the first reference signal line Vrefl through a twenty-second via hole Via22. The power supply line VDD is coupled to the power supply connection line VDD' through a twenty-third via hole Via23. The power supply line VDD is coupled to the first electrode of the power supply control transistor T5 through a twenty-fourth via hole Via24. The first initialization signal connection line Vinit1' is coupled to the first initialization signal line Vinit1 through a twenty-sixth via hole Via26. The second initialization signal connection line Vinit2' is coupled to the second initialization signal line Vinit2 through a twenty-seventh via hole Via27.

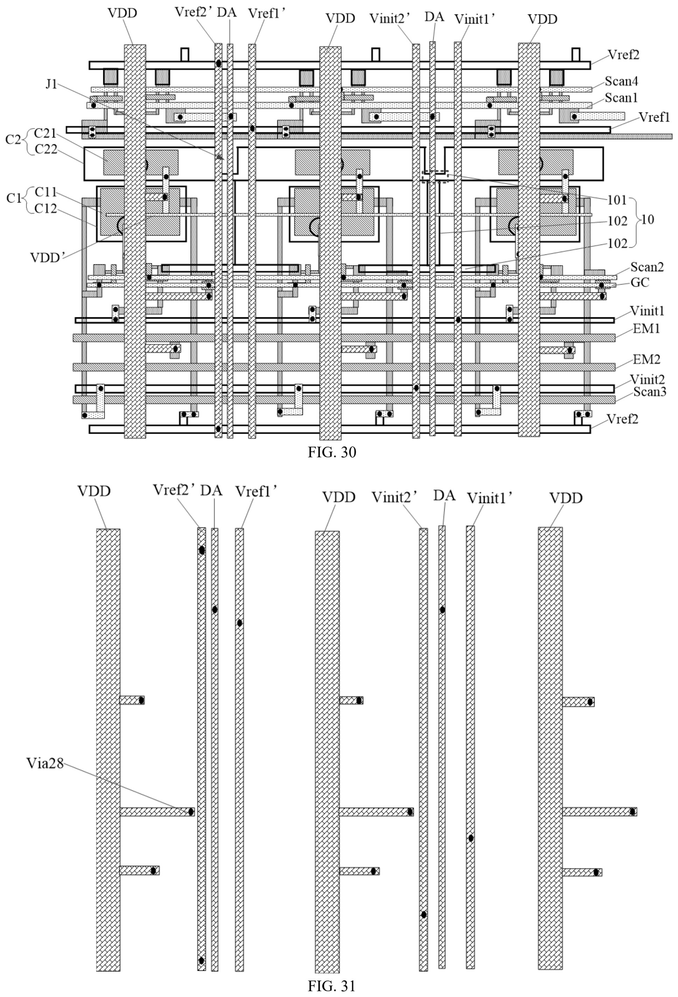

As shown in FIG. 31, the power supply line VDD is coupled to the first electrode of the second compensation transistor T10 through the twenty-eighth via hole Via28.

An embodiment of the present disclosure further provides a display device, which includes the display substrate provided in the above embodiments.

It should be noted that the display device may be any product or component with display function, such as a television, a monitor, a digital photo frame, a mobile phone, a tablet computer, etc. The display device also includes a flexible circuit board, a printed circuit board, and a back plate.

For example, the display device is suitable for notebook-sized display devices, particularly for OLED display devices of medium to large size with a high refresh rate.

In the display substrate provided in the above embodiments, a functional layer with a constant potential is arranged around the data line DA to reduce the impact of the jump of the data signal onto the node N1, and it is designed that the orthographic projection of the data line DA onto the base substrate at least partially overlaps the orthographic projection of the spacing region J1 onto the base substrate, which decreases an overlapping area between the orthographic projection of the data line DA onto the base substrate and the orthographic projection of the second plate C22 of the second capacitor C2 onto the base substrate. In this way, the loading of the data line DA can be reduced while reducing the impact of the data signal onto the node N1, and this avoids a decrease in the remote potential of the data line DA, thereby ensuring the uniformity of the display product.

The display device including the display substrate provided in the embodiments of the present disclosure also has the above-mentioned beneficial effects, which will not be repeated here.

An embodiment of the present disclosure further provides a method for driving a display substrate, for driving the display substrate provided in the above embodiments. The driving method includes: in a data writing stage, turning on the data writing transistor T1, writing a data signal transmitted by the data line DA into the second plate C12 of the first capacitor C1, to enable the first capacitor C1 to couple a potential jump of the second plate of the first capacitor to the first plate included by the first capacitor.

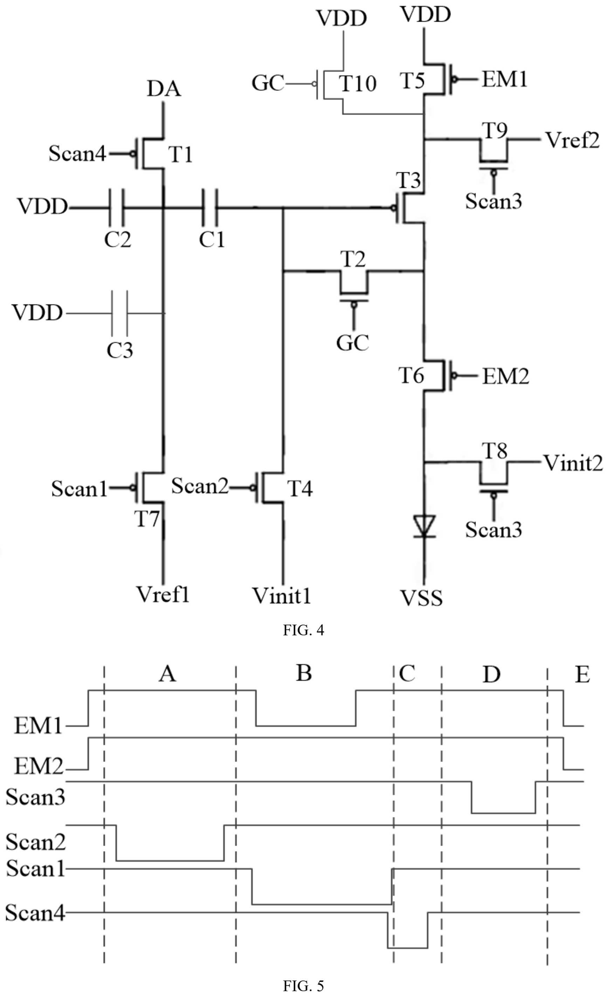

As shown in FIG. 4 and FIG. 5, in some embodiments, the sub-pixel driving circuit further includes a first compensation transistor T2 and a second compensation transistor T10. In a same sub-pixel driving circuit, the control signal line GC coupled to the gate electrode of the second compensation transistor T10 is reused as the first scan line Scan1 coupled to the gate electrode of the first compensation transistor T2. The driving method further includes: in a compensation stage, setting a control signal transmitted by the control signal line GC at an effective level to turn on both the first compensation transistor T2 and the second compensation transistor T10 under the control of the control signal, where there is a first time interval t1 between a moment when the effective level of the control signal ends and a moment when the data writing transistor T1 is turned on, and t1 satisfies t1 ≤ m, where m represents a first threshold.

In the driving method provided in the above embodiments, the effective level of the control signal can cover the compensation stage and at least part of the floating stage, which mitigates the impact of the change of the data signal on the node N1. More specifically, the above arrangement method can extend the time of the compensation stage and shorten the time of the floating stage.

It should be noted that the extension of the signal line along the X direction refers to that the signal line includes a main part and a secondary part connected to the main part, the main part is a line, a line segment or a bar-shaped body, the main part extends along the X direction, and a length of the main part extending along the X direction is greater than a length of the secondary part extending in another direction.

It should be noted that the term "same layer" in the embodiments of the present disclosure refers to film layers located on a same structural layer. Alternatively, for example, film layers on the same layer can be formed using a same film-forming process to form a specific pattern, and then patterned using a same mask through a single patterning process to form the layer structure. Depending on the specific pattern, the single patterning process may include multiple exposures, developments, or etching processes, and the specific pattern in the formed layer structure may be continuous or discontinuous. These specific shapes may also be at different heights or have different thicknesses.

In the embodiments of the method of the present disclosure, the serial number of each step cannot be used to limit an order of each step. For ordinary person in the art, the change in the order of each step shall also fall within the protection scope of the present disclosure without creative effort.

It should be noted that multiple embodiments in this specification are described in a progressive manner, reference can be made to each other for the same and similar parts between multiple embodiments, and each embodiment focuses on the differences from other embodiments. Especially for the method embodiments, the description is relatively simple, because they are basically similar to the product embodiments, and for relevant information, reference can be made to the description in the product embodiments.

Unless otherwise defined, technical or scientific terms used in the present disclosure shall have the usual meanings as understood by persons with general skills in the field to which the present disclosure belongs. Terms "first", "second" and the like in the present disclosure do not indicate any order, quantity, or importance, but are only used to distinguish different components. Word "include", "comprise" or the like refer to that an element or an object that appears before the word includes elements, or objects, or equivalents thereof listed after the word, and does not exclude other elements or objects. The term such as "connect", "couple", or "interconnect" is not limited to physical or mechanical connection, and can include electrical connection, whether direct or indirect connection. Terms such as "on", "under", "left", "right" are only used to represent a relative positional relationship, and the relative positional relationship may also change accordingly when the absolute position of the described object changes.

It is appreciated that when an element such as a layer, a film, a region, or a substrate is referred to as being located "on" or "under" another element, the element may be "directly" located "on" or "under" the other element, or there may be an intermediate element.

In the description of the above embodiments, specific features, structures, materials, or characteristics may be combined in any one or more embodiments or examples in a suitable manner.

The above embodiments are only specific implementations of the present disclosure, and the protection scope of the present disclosure is not limited thereto. Any skilled person in the art can easily think of changes or replacements within the technical scope disclosed in the present disclosure, which shall fall within the protection scope of the present disclosure. Therefore, the protection scope of the present disclosure should be subjected to the protection scope of the claims.

## Claims

1. A display substrate, comprising: a base substrate, and power supply lines, data lines and a plurality of sub-pixels that are arranged on the base substrate, wherein the sub-pixel comprises a sub-pixel driving circuit and a light-emitting element coupled to each other, and the sub-pixel driving circuit comprises a driving transistor, a data writing transistor, a first capacitor and a second capacitor;

   a first plate of the first capacitor is coupled to a gate electrode of the driving transistor, a second plate of the first capacitor is coupled to a second electrode of the data writing transistor, and a first electrode of the data writing transistor is coupled to a corresponding one of the data lines;
   a first plate of the second capacitor is coupled to the second plate of the first capacitor, and a second plate of the second capacitor is coupled to a corresponding one of the power supply lines;
   among sub-pixel driving circuits located in a same row along a first direction, second plates of second capacitors comprised in the sub-pixel driving circuits are arranged in sequence along the first direction, there is a spacing region between second plates of adjacent second capacitors, and an orthographic projection of the data line onto the base substrate at least partially overlaps an orthographic projection of the spacing region onto the base substrate.

2. The display substrate according to claim 1, wherein the second plates of the adjacent second capacitors along the first direction are coupled to each other through a plate connection part, the spacing region and the plate connection part are arranged along a second direction between the second plates of the adjacent second capacitors, and the first direction intersects the second direction; the orthographic projection of the data line onto the base substrate at least partially overlaps an orthographic projection of the plate connection part onto the base substrate.

3. The display substrate according to claim 2, wherein the display substrate further comprises a first initialization signal line; the sub-pixel driving circuit further comprises a first compensation transistor and a first reset transistor; a first electrode of the first compensation transistor is coupled to the second electrode of the driving transistor, and a second electrode of the first compensation transistor is coupled to the gate electrode of the driving transistor; a first electrode of the first reset transistor is coupled to the corresponding first initialization signal line, and a second electrode of the first reset transistor is coupled to the gate electrode of the driving transistor; the first compensation transistor comprises a first compensation active layer, and the first reset transistor comprises a first reset active layer; the plate connection part comprises a connection body portion and a connection extension portion that are coupled to each other, the connection body portion is coupled to the second plates of the adjacent second capacitors, and an orthographic projection of the connection extension portion onto the base substrate at least partially overlaps an orthographic projection of the first compensation active layer onto the base substrate comprised in one sub-pixel driving circuit of two adjacent sub-pixel driving circuits along the first direction, and/or at least partially overlaps an orthographic projection of the first reset active layer onto the base substrate comprised in another sub-pixel driving circuit of the two adjacent sub-pixel driving circuits along the first direction;
   the orthographic projection of the data line onto the base substrate at least partially overlaps an orthographic projection of the connection body portion onto the base substrate; and/or, the orthographic projection of the data line onto the base substrate at least partially overlaps the orthographic projection of the connection extension portion onto the base substrate.

4. The display substrate according to claim 3, wherein the first compensation active layer comprises two first compensation channel portions, and first compensation conductor portions respectively coupled to the two first compensation channel portions; the first reset active layer comprises two first reset channel portions, and first reset conductor portions respectively coupled to the two first reset channel portions;

the orthographic projection of the connection extension portion onto the base substrate at least partially overlaps orthographic projections of the first compensation conductor portions onto the base substrate comprised in one sub-pixel driving circuit of two adjacent sub-pixel driving circuits along the first direction, and/or at least partially overlaps orthographic projections of the first reset conductor portions onto the base substrate comprised in another sub-pixel driving circuit of the two adjacent sub-pixel driving circuits along the first direction.

5. The display substrate according to claim 1, wherein the display substrate further comprises a plurality of first reference signal connection lines and a plurality of second reference signal connection lines, and the first reference signal connection lines and the second reference signal connection lines are alternately arranged along the first direction; an orthographic projection of at least portion of the data line onto the base substrate is located between orthographic projections of the first reference signal connection line and the second reference signal connection line that are adjacent onto the base substrate; the data line and the first reference signal connection line are arranged in different layers; and/or the data line and the second reference signal connection line are arranged in different layers.

6. The display substrate according to claim 5, wherein the display substrate further comprises a plurality of first reference signal lines; the sub-pixel driving circuit further comprises a second reset transistor, a first electrode of the second reset transistor is coupled to a corresponding one of the first reference signal lines, and a second electrode of the second reset transistor is coupled to the second plate of the first capacitor; and the first reference signal connection lines are respectively coupled to the plurality of first reference signal lines.

7. The display substrate according to claim 5, wherein the display substrate further comprises a plurality of second reference signal lines; the sub-pixel driving circuit further comprises a third reset transistor, a first electrode of the third reset transistor is coupled to a corresponding one of the second reference signal line, and a second electrode of the third reset transistor is coupled to the first electrode of the driving transistor; and the second reference signal connection lines are respectively coupled to the plurality of second reference signal lines.

8. The display substrate according to claim 5, wherein the display substrate further comprises a plurality of first initialization signal connection lines and a plurality of second initialization signal connection lines, and the first initialization signal connection lines and the second initialization signal connection lines are alternately arranged along the first direction;

an orthographic projection of at least portion of the data line onto the base substrate is located between orthographic projections of a first initialization signal connection line and a second initialization signal connection line that are adjacent onto the base substrate, the data line and the first initialization signal connection line are arranged in different layers; and/or, the data line and the second initialization signal connection line are arranged in different layers.

9. The display substrate according to claim 8, wherein the display substrate further comprises a plurality of first initialization signal lines; the sub-pixel driving circuit further comprises a first reset transistor, a first electrode of the first reset transistor is coupled to a corresponding one of the first initialization signal lines, and a second electrode of the first reset transistor is coupled to the gate electrode of the driving transistor; and the first initialization signal connection lines are respectively coupled to the plurality of first initialization signal lines.

10. The display substrate according to claim 8, wherein the display substrate further comprises a plurality of second initialization signal lines; the sub-pixel driving circuit further comprises a fourth reset transistor, a first electrode of the fourth reset transistor is coupled to a corresponding one of the second initialization signal lines, and a second electrode of the fourth reset transistor is coupled to an anode of the light-emitting element; and the second initialization signal connection lines are respectively coupled to the plurality of second initialization signal lines.

11. The display substrate according to claim 8, wherein the display substrate comprises a first source-drain metal layer, a second source-drain metal layer, and a third source-drain metal layer sequentially stacked in a direction away from the base substrate;

the data line and the third source drain metal layer are arranged in a same layer and fabricated by a same material, and the first reference signal connection line, the second reference signal connection line, the first initialization signal connection line, and the second initialization signal connection line are arranged in a same layer and fabricated by a same material as the second source drain metal layer.

12. The display substrate according to claim 11, wherein the display substrate further comprises a plurality of data line leads; the display substrate comprises a plurality of data lines arranged along the first direction, and the plurality of data lines are divided into a first group of data lines, a second group of data lines and a third group of data lines arranged along the first direction;

a data line in the first group of data lines is coupled to a corresponding one of the data line leads, and the data line lead extends from a position where the data line lead and the data line are coupled to a middle area of the display substrate, and extends from the middle area to a bottom border area of the display substrate;
a data line in the third group of data lines is coupled to a corresponding one of the data line leads, and the data line lead extends from a position where the data line lead and the data line are coupled to the middle area, and extends from the middle area to the bottom border area.

13. The display substrate according to claim 8, wherein the display substrate comprises a first source-drain metal layer, a second source-drain metal layer, and a third source-drain metal layer sequentially stacked in a direction away from the base substrate; the data line and the second source drain metal layer are arranged in a same layer and fabricated by a same material, and the first reference signal connection line, the second reference signal connection line, the first initialization signal connection line, and the second initialization signal connection line are arranged in a same layer and fabricated by a same material as the third source drain metal layer.

14. The display substrate according to claim 8, wherein the display substrate comprises a light shielding layer, a first source-drain metal layer, a second source-drain metal layer and a third source-drain metal layer that are sequentially stacked in a direction away from the base substrate; the data line are arranged in a same layer and fabricated by a same material as the light shielding layer, the first reference signal connection line, the second reference signal connection line, the first initialization signal connection line, and the second initialization signal connection line are arranged in a same layer and fabricated by a same material as the second source drain metal layer.

15. The display substrate according to claim 1, wherein the display substrate further comprises a plurality of power supply connection lines, at least portion of the power supply connection lines extends along the first direction, and the power supply connection lines are respectively coupled to the plurality of power supply lines.

16. The display substrate according to claim 15, wherein the power supply connection line comprises a plurality of first power supply portions and a plurality of second power supply portions, and the first power supply portions and the second power supply portions are alternately arranged along the first direction; the first power supply portion comprises a first sub-portion and a second sub-portion, the first sub-portion is coupled to the second sub-portion and the power supply line, the second sub-portion and the second power supply portion that are adjacent are coupled to each other, a width of the second power supply portion along a second direction is greater than a width of the second sub-portion along the second direction, and an orthographic projection of the second power supply portion onto the base substrate at least partially overlaps the orthographic projection of the data line onto the base substrate.

17. The display substrate according to any one of claims 1 to 16, wherein the sub-pixel further comprises a first scan line and a control signal line; the sub-pixel driving circuit further comprises a first compensation transistor and a second compensation transistor, a gate electrode of the first compensation transistor is coupled to the corresponding first scan line, a first electrode of the first compensation transistor is coupled to the second electrode of the driving transistor, and a second electrode of the first compensation transistor is coupled to the gate electrode of the driving transistor; a gate electrode of the second compensation transistor is coupled to the corresponding control signal line, a first electrode of the second compensation transistor is coupled to a corresponding one of the power supply lines, and a second electrode of the second compensation transistor is coupled to the first electrode of the driving transistor.

18. The display substrate according to claim 17, wherein in one of the sub-pixel drive circuits, the control signal line coupled to the gate electrode of the second compensation transistor is reused as the first scan line coupled to the gate electrode of the first compensation transistor.

19. The display substrate according to any one of claims 1 to 16, wherein the plurality of sub-pixels comprise a red sub-pixel, a green sub-pixel and a blue sub-pixel, the sub-pixel driving circuit in the red sub-pixel comprises a driving transistor having a first channel width-to-length ratio, the sub-pixel driving circuit in the green sub-pixel comprises a driving transistor having a second channel width-to-length ratio, and the sub-pixel driving circuit in the blue sub-pixel comprises a driving transistor having a third channel width-to-length ratio; the third channel width-to-length ratio is greater than the first channel width-to-length ratio; and/or, the third channel width-to-length ratio is greater than the second channel width-to-length ratio.

20. A display device, comprising the display substrate according to any one of claims 1 to 19.

21. A method for driving the display substrate according to any one of claims 1 to 19, comprising: in a data writing stage, turning on the data writing transistor, writing a data signal transmitted by the data line into the second plate of the first capacitor, to enable the first capacitor to couple a potential jump of the second plate of the first capacitor to the first plate comprised by the first capacitor.

22. The method for driving the display substrate according to claim 21, wherein the sub-pixel driving circuit further comprises a first compensation transistor and a second compensation transistor, among one of the sub-pixel driving circuits, a control signal line coupled to a gate electrode of the second compensation transistor is reused as a first scan line coupled to a gate electrode of the first compensation transistor; the driving method further comprises: in a compensation stage, setting a control signal transmitted by the control signal line at an effective level to turn on both the first compensation transistor and the second compensation transistor under the control of the control signal, wherein there is a first time interval t1 between a moment when the effective level of the control signal ends and a moment when the data writing transistor is turned on, t1 satisfies $t1 \leq m$, and m represents a first threshold.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

Vref2'    DA    101    Vref1'

FIG. 18

VDD   Vref2'  DA Vref1'    VDD   Vinit2'  DA Vinit1'   VDD

Vref2

J1

Scan4
Scan1

Vref1

C2 { C21
     C22

F5      F6

C1 { C11
     C12

101 }
102 } 10
102

VDD'

Scan2
Scan1

Vinit1
EM1

EM2

Vinit2
Scan3

Vref2

FIG. 19

FIG. 20

FIG. 21

FIG. 22

FIG. 23

EP 4 682 861 A1

FIG. 24

FIG. 25

FIG. 26

FIG. 27

FIG. 28

FIG. 29

FIG. 30

FIG. 31

EP 4 682 861 A1

FIG. 32

FIG. 33

FIG. 34

## INTERNATIONAL SEARCH REPORT

| | International application No. |
|---|---|
| | **PCT/CN2023/131251** |

**A. CLASSIFICATION OF SUBJECT MATTER**

G09G3/3208(2016.01)i; G09G3/3233(2016.01)i; H01L27/12(2006.01)i

According to International Patent Classification (IPC) or to both national classification and IPC

**B. FIELDS SEARCHED**

Minimum documentation searched (classification system followed by classification symbols)

IPC:G09G H01L

Documentation searched other than minimum documentation to the extent that such documents are included in the fields searched

Electronic data base consulted during the international search (name of data base and, where practicable, search terms used)

CNABS; CNTXT; CNKI; VEN; WPABS; USTXT; EPTXT; WOTXT: 像素, 象素, 画素, 电路, 驱动, 补偿, 第一, 第二, 存储, 电容, 单元, 模块, 数据, 投影, 重叠, 交叠, 重合, pixel?, drive, driving, circuit?, compensat+, second, capacitor?, storage, capacitance, voltage, data, module, unit, writ+, project+, overlap+

**C. DOCUMENTS CONSIDERED TO BE RELEVANT**

| Category* | Citation of document, with indication, where appropriate, of the relevant passages | Relevant to claim No. |
|---|---|---|
| A | CN 115831047 A (BOE TECHNOLOGY GROUP CO., LTD. et al.) 21 March 2023 (2023-03-21) description, paragraphs [0071]-[0268], and figures 2-22 | 1-21 |
| A | CN 105575331 A (AU OPTRONICS CORP.) 11 May 2016 (2016-05-11) entire document | 1-21 |
| A | CN 114724514 A (BOE TECHNOLOGY GROUP CO., LTD. et al.) 08 July 2022 (2022-07-08) entire document | 1-21 |
| A | CN 111108545 A (HUAWEI TECHNOLOGIES CO., LTD.) 05 May 2020 (2020-05-05) entire document | 1-21 |
| A | JP 2005099247 A (TOPPOLY OPTOELECTRONICS CORP.) 14 April 2005 (2005-04-14) entire document | 1-21 |
| A | CN 112823422 A (BOE TECHNOLOGY GROUP CO., LTD. et al.) 18 May 2021 (2021-05-18) entire document | 1-21 |

☑ Further documents are listed in the continuation of Box C. ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **07 April 2024** | **01 May 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/131251** |

**C.    DOCUMENTS CONSIDERED TO BE RELEVANT**

| Category* | Citation of document, with indication, where appropriate, of the relevant passages | Relevant to claim No. |
| --- | --- | --- |
| A | CN 116741105 A (YUNGU (GU'AN) TECHNOLOGY CO., LTD.) 12 September 2023 (2023-09-12)<br>        entire document | 1-21 |
| A | WO 2023193207 A1 (BOE TECHNOLOGY GROUP CO., LTD.) 12 October 2023 (2023-10-12)<br>        entire document | 1-21 |

Form PCT/ISA/210 (second sheet) (July 2022)

**INTERNATIONAL SEARCH REPORT**
Information on patent family members

| International application No. |
| --- |
| **PCT/CN2023/131251** |

| Patent document cited in search report | | | Publication date (day/month/year) | Patent family member(s) | | | Publication date (day/month/year) |
| --- | --- | --- | --- | --- | --- | --- | --- |
| CN | 115831047 | A | 21 March 2023 | None | | | |
| CN | 105575331 | A | 11 May 2016 | None | | | |
| CN | 114724514 | A | 08 July 2022 | None | | | |
| CN | 111108545 | A | 05 May 2020 | None | | | |
| JP | 2005099247 | A | 14 April 2005 | None | | | |
| CN | 112823422 | A | 18 May 2021 | None | | | |
| CN | 116741105 | A | 12 September 2023 | None | | | |
| WO | 2023193207 | A1 | 12 October 2023 | WO | 2023193207 | A9 | 01 February 2024 |